# EUROPEAN PATENT APPLICATION

(11) **EP 4 440 276 A1**
(43) Date of publication of application: **02.10.2024**
(21) Application number: 23214205.9
(22) Date of filing: 05.12.2023
(51) Int. Cl.: H10B 12/00

(54) **SEMICONDUCTOR DEVICE AND METHOD OF MANUFACTURING THE SAME**

(30) Priority: 31.03.2023 KR 20230042855
(71) Applicant: Samsung Electronics Co., Ltd., Suwon-si, Gyeonggi-do 16677 (KR)
(72) Inventor: JUNG, Myunghun, 16677 Suwon-si (KR); WOO, Kyuwon, 16677 Suwon-si (KR); SHIN, Donghwa, 16677 Suwon-si (KR); YEO, Sung-Jin, 16677 Suwon-si (KR); RYU, Ho-In, 16677 Suwon-si (KR)
(74) Representative: Marks & Clerk LLP

(57) **Abstract**

A semiconductor device includes a substrate including a cell block region and a peripheral region adjacent to each other in a first direction, first and second active patterns adjacent to each other in a second direction that is different from the first direction on the cell block region, a first bit line extending in the first direction on the first active pattern, a second bit line extending in the first direction on the second active pattern, a bit line connector connecting the first bit line and the second bit line to each other and adjacent to the peripheral region, an inner spacer on an inner surface of the bit line connector, and an outer spacer on an outer surface of the bit line connector. The inner spacer extends on (e.g., covers) the inner surface of the bit line connector and extends onto (e.g., continuously extends onto) inner surfaces of the first bit line and the second bit line.

## Description

### CROSS-REFERENCE TO RELATED APPLICATION(S)

### BACKGROUND OF THE INVENTION

The present disclosure relates to a semiconductor, and more particularly, relates to a semiconductor device and a method of manufacturing the same.

Semiconductor devices have an important role in the electronic industry because of their small size, multi-functionality, and/or low fabrication cost. Semiconductor devices may be categorized as one of semiconductor memory devices storing logic data, semiconductor logic devices processing operations of logic data, and hybrid semiconductor devices having both memory and logic elements.

Semiconductor devices of electronic products with high operating speed and/or lower operating voltage may be beneficial for high speed and low power consumption of electronic products, and thus various research has been conducted for semiconductor devices with the high integration density.

### SUMMARY

An object of the present disclosure is to provide a semiconductor device with improved integration and a method of manufacturing the same.

An object of the present disclosure is to provide a semiconductor device with improved electrical characteristics and reliability.

The problem to be solved by the present disclosure is not limited to the problems mentioned above, and other problems not mentioned will be clearly understood by those skilled in the art from the description below.

A semiconductor device according to some embodiments of the present invention may include a substrate including a cell block region and a peripheral region adjacent to each other in a first direction, first and second active patterns adjacent to each other in a second direction that is different from (e.g., crosses) the first direction on the cell block region, a first bit line extending in the first direction on the first active pattern, a second bit line extending in the first direction on the second active pattern, a bit line connector connecting the first bit line and the second bit line to each other and adjacent to the peripheral region, an inner spacer on an inner surface of the bit line connector, and an outer spacer on an outer surface of the bit line connector. The inner spacer may extend on (e.g., cover) the inner surface of the bit line connector and extend onto inner surfaces of the first bit line and the second bit line.

A semiconductor device according to some embodiments of the present invention may include a substrate including a cell block region and a peripheral region adjacent to each other in a first direction, first and second active patterns adjacent to each other in a second direction that is different from (e.g., crosses) the first direction on the cell block region, a first bit line extending in the first direction on the first active pattern, a second bit line extending in the first direction on the second active pattern, a bit line connector that connects the first bit line and the second bit line to each other and is adj acent to the peripheral region, an inner spacer on an inner surface of the bit line connector, and an outer spacer on an outer surface of the bit line connector. The inner spacer may be rounded toward the peripheral region. In some embodiments, the inner spacer may be curved toward the peripheral region in a plan view.

A semiconductor device according to some embodiments of the present invention may include a substrate including a cell block region and a peripheral region adjacent to each other in a first direction, first and second active patterns adjacent to each other in a second direction that is different from (e.g., crosses) the first direction on the cell block region, a first bit line extending along the first direction on the first active pattern, a second bit line extending along the first direction on the second active pattern, a bit line connector connecting the first bit line and the second bit line to each other and adj acent to the peripheral region, an inner spacer on an inner surface of the bit line connector, an outer spacer on an outer surface of the bit line connector, bit line node contacts between the first bit line and the first active pattern and between the second bit line and the second active pattern, storage node contacts on edge portions of the first and second active patterns, respectively, landing pads on the storage node contacts, respectively, and a data storage pattern on the landing pads, respectively. The inner spacer may extend on (e.g., cover) the inner surface of the bit line connector and may continuously extend onto inner surfaces of the first bit line and the second bit line.

A method of manufacturing a semiconductor device according to some embodiments of the present invention may include providing or preparing a substrate including a cell block region and a peripheral region adjacent to each other in a first direction, forming a bit line layer on the cell block region, forming lower mask patterns that are on the bit line layer and extend in the first direction, forming spacer mask patterns extending around (e.g., surrounding) side surfaces of the lower mask patterns, forming a peripheral mask pattern on the peripheral region and spaced apart from the spacer mask patterns in the first direction, and etching the bit line layer using the spacer mask pattern and the peripheral mask pattern as etching masks to form bit line structures.

At least some of the above and other features of the invention are set out in the claims.

### BRIEF DESCRIPTION OF THE DRAWINGS

Example embodiments will be more clearly understood from the following description taken in conjunction with the accompanying drawings. The accompanying drawings represent non-limiting, example embodiments as described herein.
FIG. 1 is a view illustrating a substrate on which semiconductor devices according to some embodiments of the present invention are integrated.
FIGS. 2A and 2B are enlarged views corresponding to 'X1' in FIG. 1 according to some embodiments of the present invention.
FIGS. 3A and 3B are views illustrating cell block group regions of FIGS. 2A and 2B according to some embodiments of the present invention.
FIG. 4A is a plan view illustrating a portion of a first cell block region and a portion of a peripheral region of FIG. 3A according to some embodiments of the present invention.
FIG. 4B is an enlarged view corresponding to `X2' in FIG. 4A according to some embodiments of the present invention.
FIGS. 5A and 5B are cross-sectional views corresponding to lines A-A' and B-B' of FIG. 4A, respectively, according to some embodiments of the present invention.
FIG. 6 is a cross-sectional view corresponding to the line A-A' of FIG. 4A according to some embodiments of the present invention.
FIG. 7 is a plan view illustrating a portion of a first cell block region and a portion of a peripheral region of FIG. 3A according to some embodiments of the present invention.
FIG. 8 is a plan view illustrating a portion of a first cell block region and a portion of a peripheral region of FIG. 3A according to some embodiments of the present invention.
FIG. 9 is a plan view illustrating a portion of a second cell block region and a portion of a peripheral region of FIG. 3A according to some embodiments of the present invention.
FIGS. 10, 11A, 11B, 12, 13A, 13B, 14, 15A, 15B, 16, 17A, 17B, 18, 19A and 19B are views illustrating a method of manufacturing a semiconductor device according to some embodiments of the present invention.
FIGS. 20A, 20B, 20C, 20D and 20E are plan views illustrating a portion of a first cell block region and a portion of a peripheral region of FIG. 3A according to some embodiments of the present invention.

### DETAILED DESCRIPTION

Hereinafter, to explain the present invention in more detail, some example embodiments according to the present invention will be described in more detail with reference to the accompanying drawings.

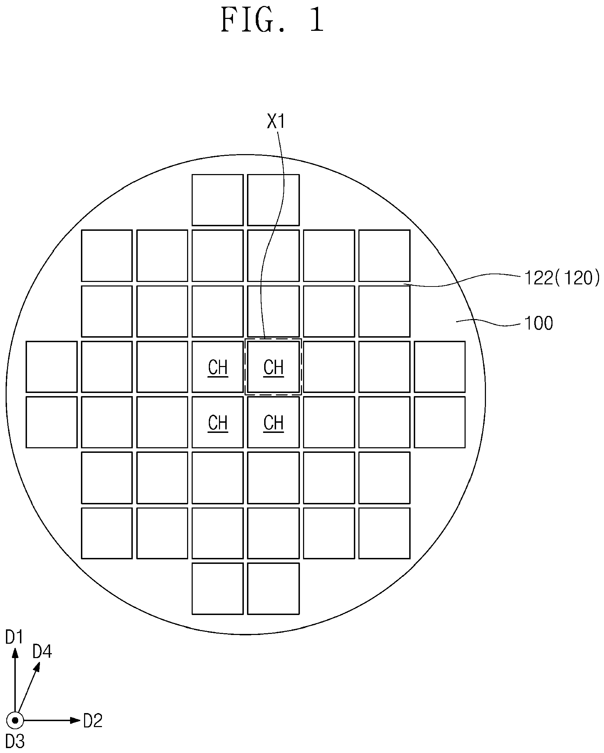

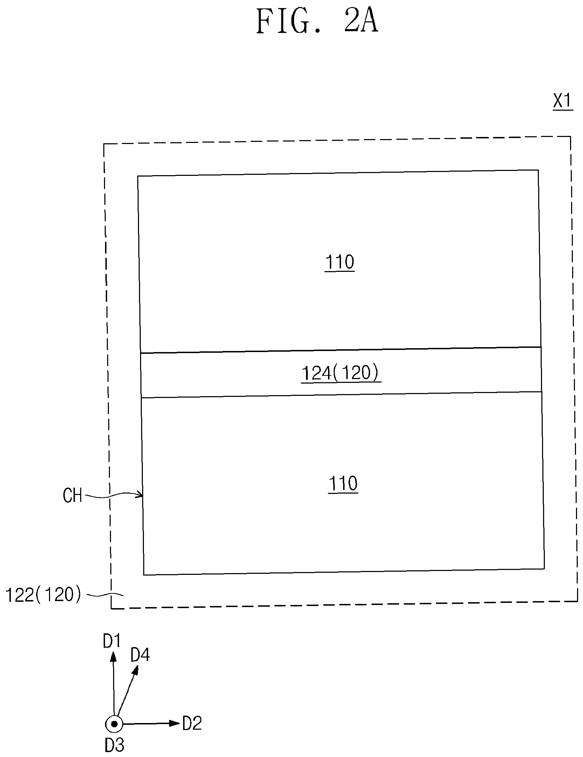

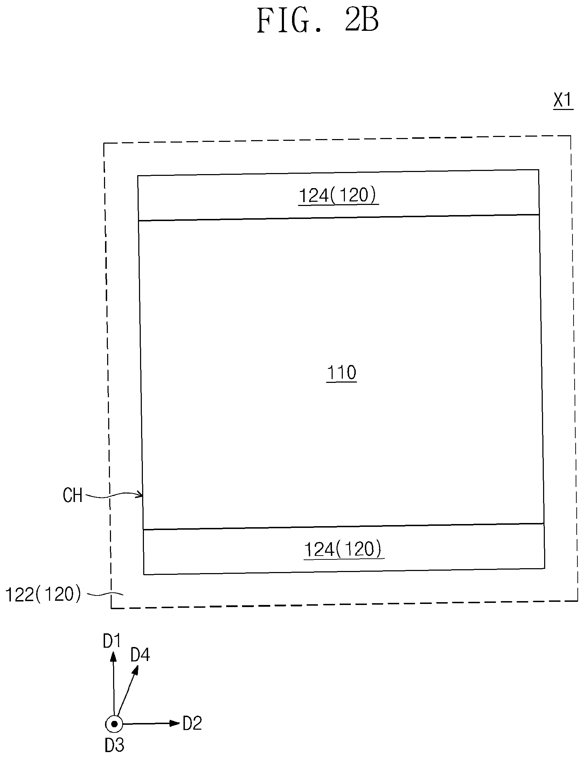

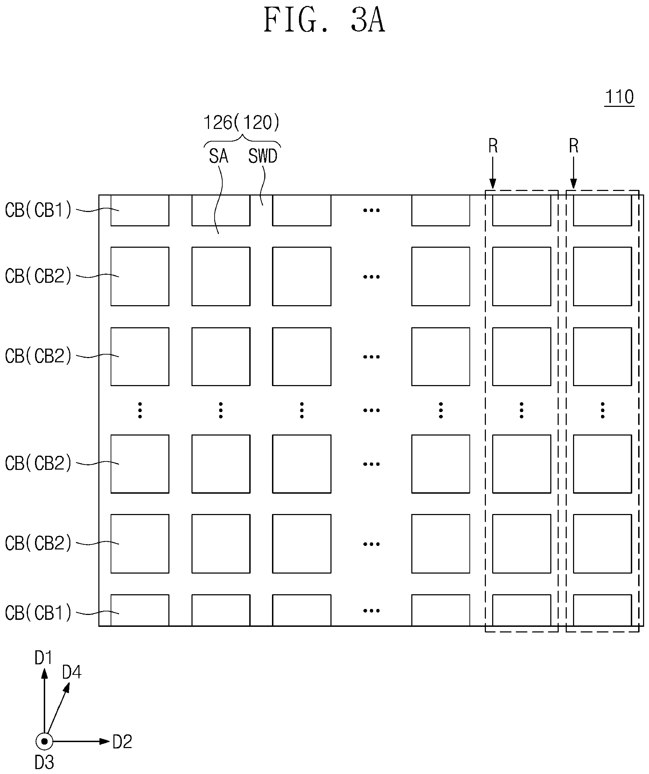

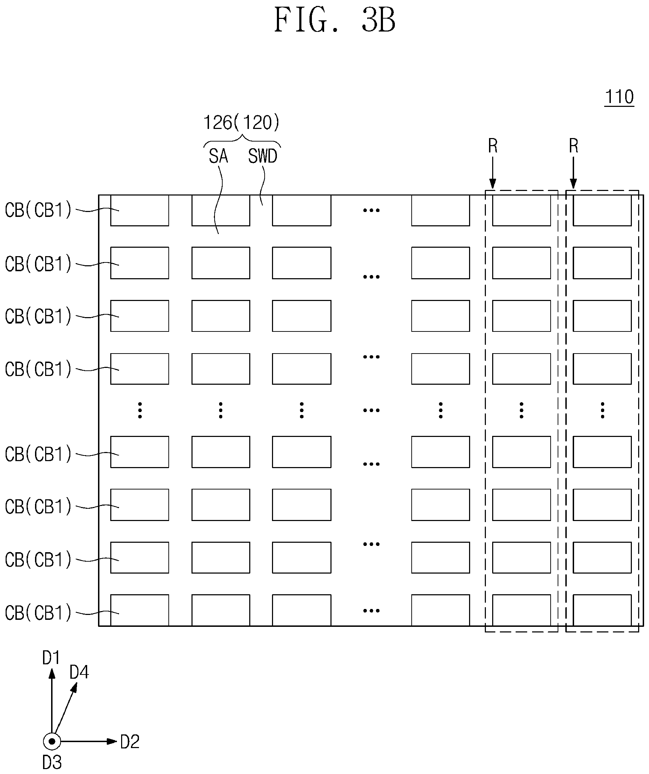

FIG. 1 is a view illustrating a substrate on which semiconductor devices according to some embodiments of the present invention are integrated. FIGS. 2A and 2B are enlarged views corresponding to 'X1' in FIG. 1 according to some embodiments of the present invention. FIG. 3A is a view illustrating cell block group regions of FIGS. 2A and 2B according to some embodiments of the present invention. FIG. 3B is a view illustrating cell block group regions of FIGS. 2A and 2B according to some embodiments of the present invention.

Referring to FIG. 1, a substrate 100 may include chip regions CH where semiconductor integrated circuits are disposed, and a scribe lane region 122 between the chip regions CH. The substrate 100 may be one of a semiconductor substrate, for example, a silicon substrate, a germanium substrate, or a silicon-germanium substrate. In the present specification, each of phrases such as "A or B", "at least one of A and B", "at least one of A or B", "A, B or C", "at least one of A, B and C", and "at least one of A, B, or C" may include one of the items listed together in that phrase, or all possible combinations thereof.

The chip regions CH may be two-dimensionally arranged in a first direction D1 and a second direction D2 that may be different from (e.g., orthogonal to) the first direction D1. The first and second directions D1 and D2, respectively, may be parallel to a lower surface of the substrate 100. Each of the chip regions CH may be extended around by (e.g., surrounded by) a scribe lane region 122.

The scribe lane region 122 may include a plurality of first scribe lane regions extending along the first direction D1, and a plurality of second scribe lane regions intersecting the first scribe lane regions and extending along the second direction D2. The scribe lane region 122 may include a cutting lane region cut by a sawing or cutting machine, and edge lane regions between the cutting lane region and the chip regions CH. The edge lane regions may extend around (e.g., surround) the chip regions CH, respectively. For example, when viewed in a plan view, the cutting lane region may be interposed between neighboring chip regions CH, and the edge lane regions may be interposed between the chip regions CH and the cutting lane region. As used herein, "extending along" may be interchangeable with "extending in," and "an element A extends in a direction X" (or similar language) may mean that the element A extends longitudinally in the direction X.

Semiconductor devices may be provided on the chip regions CH of the substrate 100. For example, semiconductor memory devices such as dynamic random access memory (DRAM), static random access memory (SRAM), NAND flash memory, and resistive random access memory (RRAM) may be provided on the chip regions CH. As another example, a processor such as a micro electro mechanical systems (MEMS) device, an optoelectronic device, a CPU, or a DSP may be provided on the chip regions CH. As another example, standard cells including semiconductor devices such as an OR gate or an AND gate may be provided on the chip regions CH of the substrate 100.

Referring to FIGS. 2A and 2B, each of the chip regions CH may include a peripheral region 124 and a cell block group region 110. Peripheral circuits may be provided on the peripheral region 124. The peripheral circuits may perform, for example, command/address, power generation, and/or data input/output (DQ).

Each of the chip regions CH may include one or a plurality of peripheral regions 124 and may include one or a plurality of cell block group regions 110. For example, as shown in FIG. 2A, the chip region CH may include a pair of cell block group regions 110 adjacent to each other in the first direction D1 and a peripheral region 124 therebetween. As another example, as shown in FIG. 2B, the chip region CH may include a pair of adj acent peripheral regions 124 spaced apart from each other in the first direction D1 and a cell block group region 110 therebetween. However, this is provided only as an example, and the present invention is not limited thereto. The cell block group region 110 may be adjacent to either the scribe lane region 122 or the peripheral region 124 in the first direction D1 or in an opposite direction thereto.

Referring to FIGS. 3A and 3B, the cell block group region 110 may include a plurality of cell block regions CB and core regions 126 extending around (e.g., surrounding) the cell block regions CB. Core circuits may be provided on the core region 126. The core circuits may sense and control bit lines BL and/or word lines WL, which will be described later, on the cell block region CB. For example, the core circuits may include sense amplifier circuits SA to sense the bit lines BL and sub word line driver circuits SWD to control the word lines WL. The sense amplifier circuits SA may face each other in the first direction D1 with the cell block regions CB interposed therebetween. The sub word line driver circuits SWD may face each other in the second direction D2 with the cell block regions CB interposed therebetween.

The cell block regions CB may be spaced apart from each other in first and second directions D1 and D2. For example, the cell block regions CB may include cell block columns R arranged in the first direction D1, and the plurality of cell block columns R may be spaced apart from each other in the second direction D2. The cell block column R may include a first cell block region CB 1. For example, the cell block column R may further include a second cell block region CB2. For example, a folded bit line may be provided on the first cell block region CB1 and may be not provided on the second cell block region CB2. For example, in the first direction D1, a width of the first cell block region CB1 may be narrower than that of the second cell block region CB2.

For example, as shown in FIG. 3A, the cell block column R may include a pair of first cell block regions CB1 respectively disposed at both ends in the first direction D1 and a second cell block regions CB2 therebetween. The pair of first cell block regions CB1 may be disposed at edges of the cell block group region 110 in the first direction D1. For example, each of the pair of first cell block regions CB 1 may be adjacent to the scribe lane region 122 or the peripheral region 124. For example, the second cell block regions CB2 may be extended around by (e.g., surrounded by) the core region 126. As another example, as shown in FIG. 3B, the cell block column R may include a plurality of first cell block regions CB1 disposed in the first direction D1. However, the present invention is not limited thereto, and each of the cell block columns R may include a first cell block region CB1 and/or a second cell block region CB2 arranged in various orders.

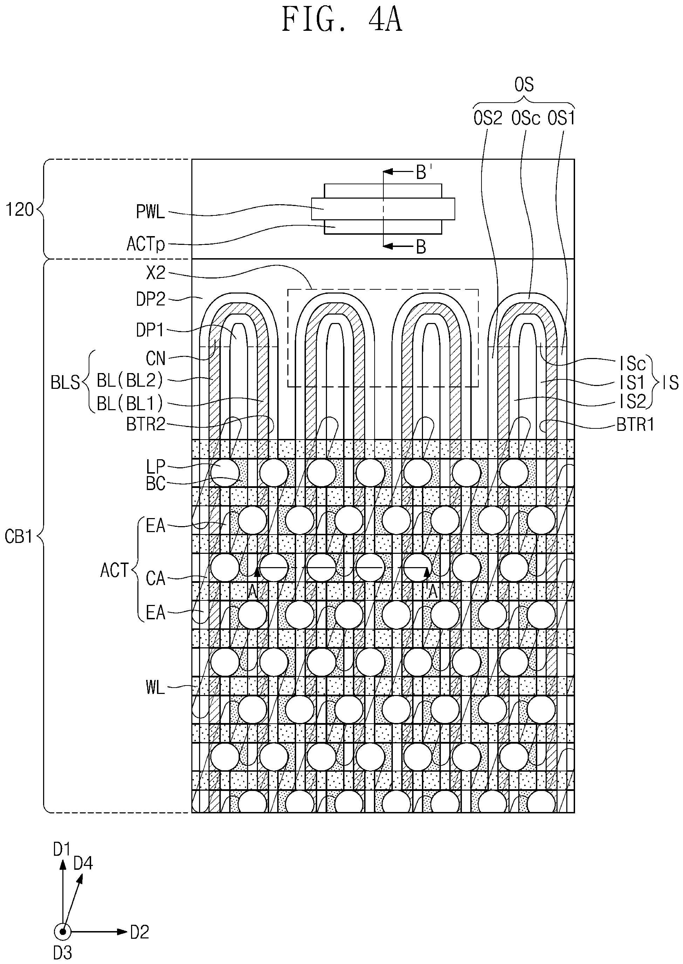

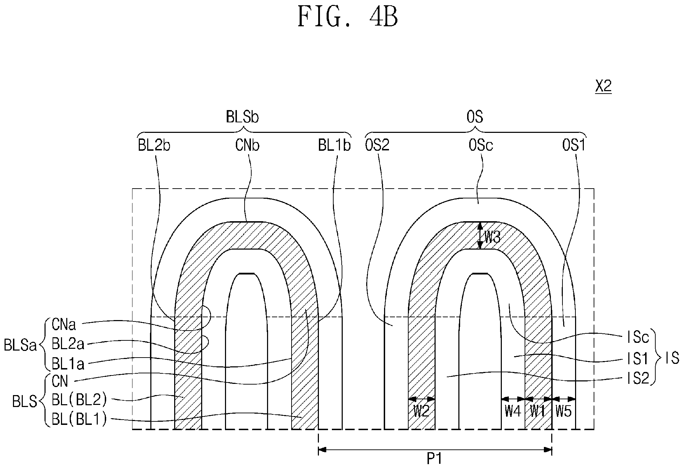

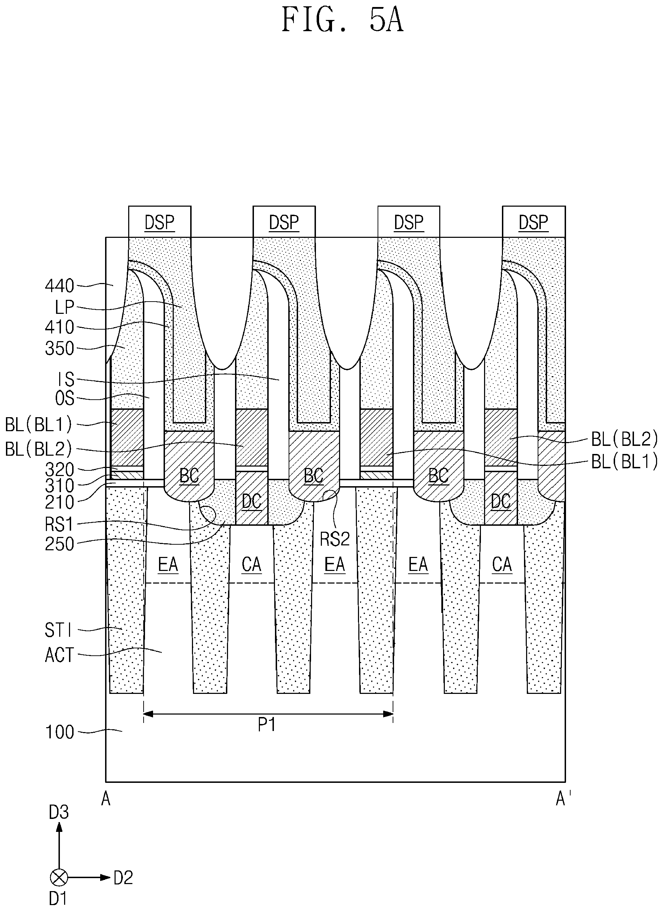

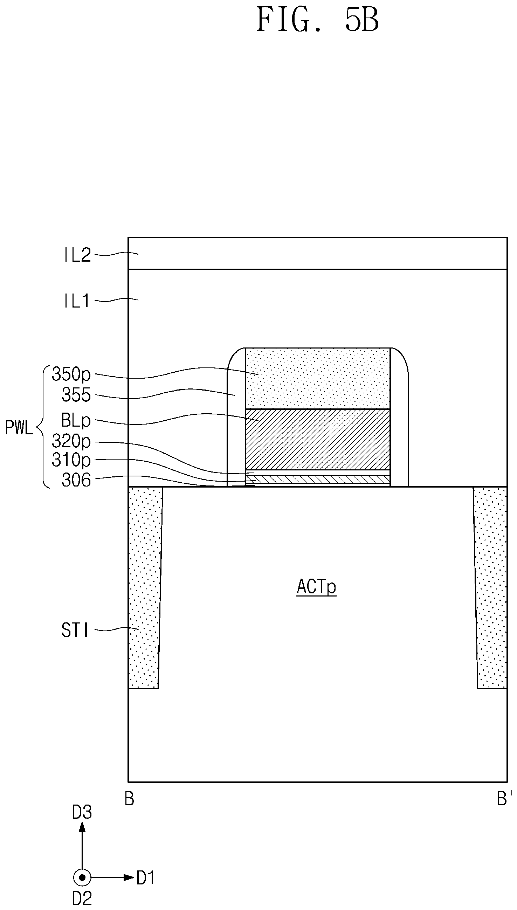

FIG. 4A is a plan view illustrating a portion of a first cell block region CB1 and a portion of a peripheral region of FIG. 3A. FIG. 4B is an enlarged view corresponding to `X2' in FIG. 4A. FIGS. 5A and 5B are cross-sectional views taken along the lines A-A' and B-B' of FIG. 4A, respectively.

Referring to FIGS. 4A to 5B, a substrate 100 may include a first cell block region CB1 and a peripheral region 120 adjacent to the first cell block region CB1 (e.g., a side surface of the first cell block region CB1 in the first direction D1). The first cell block region CB1 may be the same as the first cell block region CB1 described with reference to FIGS. 3A and 3B. The peripheral region 120 may include the scribe lane region 122, the peripheral region 124, and the core region 126 described with reference to FIGS. 1 to 3B.

A device isolation pattern STI may be disposed in the substrate 100. The device isolation pattern STI may define active patterns ACT on the first cell block region CB1 and may define a peripheral active pattern ACTp on the peripheral region 120.

The active patterns ACT and the peripheral active patterns ACTp may protrude in a third direction D3 perpendicular to a lower surface of the substrate 100. For example, the active patterns ACT and the peripheral active patterns ACTp may be portions of the substrate 100 extended around by (e.g., surrounded by) the device isolation pattern STI. For convenience of description, unless otherwise specified, the substrate 100 in this specification is defined as referring to other portions of the substrate 100 excluding the active patterns ACT and the peripheral active patterns ACTp.

Each of the active patterns ACT may have an island shape separated from each other and may have a bar shape elongated in a fourth direction D4. The fourth direction D4 may be parallel to the lower surface of the substrate 100 and may be different from (e.g., cross) the first and second directions D1 and D2.

Each of the active patterns ACT may include a pair of edge portions EA and a center portion CA. The pair of edge portions EA may be end portions of the active pattern ACT in the fourth direction D4, respectively. The center portion CA may be a portion of the active pattern ACT interposed between a pair of edge portions EA, and in detail, may be a portion of an active pattern ACT interposed between a pair of word lines WL, which will be described later. An impurity (e.g., n-type or p-type impurity) may be doped into the pair of edge portions EA and center portion CA.

The active patterns ACT may be adjacent to each other in the first direction D1 and the second direction D2. In the present specification, the fact that the active patterns ACT are adjacent to each other in the first direction D1 means that the center portions CA of the active patterns ACT adjacent to each other are disposed in the first direction D1. In the present specification, the fact that the active patterns ACT are adjacent to each other in the second direction D2 means that a center portion CA of one active pattern ACT and an edge portion EA of another active patterns ACT adjacent to the one active pattern are arranged in the second direction D2. In some embodiments two active patterns ACT may be directly adjacent to each other in the first direction D1 and the second direction D2. It will be understood that the term "directly adjacent" as used herein includes configurations where two "elements" (such as two active patterns ACT) which are said to be directly adjacent to one another are positioned so that no other like element is located between the two elements which are said to be directly adjacent to one another.

The device isolation pattern STI may include an insulating material, and for example, may include at least one of silicon oxide and silicon nitride. The device isolation pattern STI may be a single layer formed of a single material or a composite layer including two or more materials.

A word line WL may be provided in the active patterns ACT. The word line WL may be provided in plural. The word lines WL may extend along the second direction D2 and may be spaced apart from each other in the first direction D1. The word lines WL may be disposed in trenches provided in the active patterns ACT and the device isolation pattern STI. For example, a pair of word lines WL adjacent to each other in the first direction D1 may cross one active pattern ACT.

Each of the word lines WL may include a gate electrode (not shown), a gate dielectric pattern (not shown), and a gate capping pattern (not shown). The gate electrode may pass through the active patterns ACT and the device isolation pattern STI in the second direction D2. The gate dielectric pattern may be interposed between the gate electrode and the active patterns ACT and between the gate electrode and the device isolation pattern STI. The gate capping pattern may cover an upper surface of the gate electrode on the gate electrode. For example, the gate electrode may include a metal material (e.g., Ti, Mo, W, Cu, Al, Ta, Ru, Ir, etc.). For example, the gate insulating pattern may include at least one of silicon oxide and a high-k material. In this specification, the high-k material is defined as a material having a higher dielectric constant than that of silicon oxide. For example, the gate capping pattern may include silicon nitride.

A buffer pattern 210 may be disposed on the substrate 100. The buffer pattern 210 may cover the active patterns ACT, the device isolation pattern STI, and the word lines WL. For example, the buffer pattern 210 may include at least one of silicon oxide, silicon nitride, silicon oxynitride, or a combination thereof. The buffer pattern 210 may be a single layer formed of a single material or a composite layer including two or more materials.

A bit line node contact DC may be provided on each of the active patterns ACT, and may be provided in plural. The bit line node contacts DC may be electrically connected to the center portions CA of the active patterns ACT, respectively. The bit line node contacts DC may be spaced apart from each other in first and second directions D1 and D2. The bit line node contacts DC may be interposed between the active patterns ACT and bit lines BL, which will be described later. The bit line node contact DC may electrically connect a corresponding bit line BL among the bit lines BL and the center portions CA of the corresponding active pattern ACT.

The bit line node contacts DC may be respectively disposed in first recess regions RS 1. The first recess regions RS 1 may be provided on upper portions of the active patterns ACT and on upper portions of the device isolation pattern STI adjacent to the upper portions of the active patterns ACT. The first recess regions RS1 may be spaced apart from each other in first and second directions D1 and D2.

A buried insulating pattern 250 may fill each of the first recess regions RS 1. The buried insulating pattern 250 may fill an inside of the first recess region RS 1. For example, the buried insulating pattern 250 may cover an inner surface of the first recess region RS 1 and at least a portion of a side surface of the bit line node contact DC (e.g., at least a portion of a side surface of the bit line mode contact DC in the first recess region RS 1). The buried insulating pattern 250 may include, for example, at least one of silicon oxide, silicon nitride, or a combination thereof. The buried insulating pattern 250 may be a single layer formed of a single material or a composite layer including two or more materials.

A bit line structure BLS may be disposed on the active pattern ACT. The bit line node contact DC may electrically connect the bit line structure BLS to the active pattern ACT. For example, the bit line node contact DC may electrically connect a bit line BL of the bit line structure BLS, which will be described later, to the active pattern ACT. The bit line structure BLS may be provided in plural. The bit line structures BLS may each extend along the first direction D1 and may be adjacent to each other in the second direction D2. One bit line structure BLS may extend along the first direction D1 on active patterns ACT adjacent to each other in the second direction D2.

The bit line structure BLS may be a folded bit line and may include bit lines BL adjacent to each other in the second direction D2. The neighboring bit lines BL may be electrically connected to each other and driven together by applying one electrical signal. For example, when an electrical signal is directly applied to one of the neighboring bit lines BL during driving of the semiconductor device, the electrical signal may be transmitted to the other one of the neighboring bit lines BL.

For example, the bit line structure BLS may include a first bit line BL1 and a second bit line BL2 adjacent to each other in the second direction D2, and a bit line connector CN electrically connecting them to each other. The first bit line BL1 and the second bit line BL2 may each extend along the first direction D1. For example, the first bit line BL1 may be provided on one of the neighboring active patterns ACT in the second direction D2, and the second bit line BL2 may be provided on the other one thereof. For example, the bit line connector CN may physically connect the first bit line BL1 and the second bit line BL2 and may be in contact with each of the first bit line BL 1 and the second bit line BL2 without a boundary or a visible interface. For example, when an electrical signal is directly applied to the first bit line BL1 during driving of the semiconductor device, the electrical signal may also be transmitted to the second bit line BL2 through the bit line connector CN. For example, the bit line connector CN may be curved or rounded toward the peripheral region 120. As used herein "being rounded toward" may be interchangeable with "being curved toward."

The bit line connector CN may be adjacent to the peripheral region 120 on the first cell block region CB1. For example, the peripheral region 120 may be a scribe lane region 122 or a peripheral region 124. When the bit line connector CN is configured to be adjacent to the scribe lane region 122 or the peripheral region 124, one bit line BL may be easily connected to the core circuit through another bit line BL although the one bit line BL is disposed relatively far from the core circuit. Accordingly, the number of bit lines BL not connected to the core circuit may be reduced. As another example, the peripheral region 120 may be the core region 126. In this case, the plurality of bit lines BL may be effectively controlled with only a small number of core circuits. As a result, the bit line connector CN may be provided to improve integration of the semiconductor device.

The bit line structure BLS may include a metal material (e.g., Ti, Mo, W, Cu, Al, Ta, Ru, Ir, etc.). For example, each of the first bit line BL1, the second bit line BL2, and the bit line connector CN may include a metal material (e.g., Ti, Mo, W, Cu, Al, Ta, Ru, Ir, etc.). For example, the first bit line BL1, the second bit line BL2, and the bit line connector CN may include the same material.

The bit line structure BLS may have a first pitch P1 in the second direction D2. That is, the first and second bit lines BL1 and BL2 may have the first pitch P1 in the second direction D2. In this specification, "pitch" means a minimum distance in which the same components are repeatedly disposed. For example, the first pitch P1 may be greater than 0 nm and equal to or less than 130 nm. When the first pitch P1 has a value of 130 nm or less, integration of the bit line structure BLS may be improved. In addition, when the first pitch P1 has a value of 130 nm or less, the bit line structure BLS may be formed through multi-patterning technology, which will be described later, and as a result, productivity may be improved.

In the second direction D2, the first bit line BL1 may have a first width W1, and the second bit line BL2 may have a second width W2. For example, each of the first width W1 and the second width W2 may be greater than 0 nm and may be equal to or less than 14 nm. When each of the first width W1 and the second width W2 has a value of 14 nm or less, the bit line structure BLS may be formed through a multi-patterning technique to be described later.

A third width W3 may be defined as a distance from one side (e.g., one end) of an inner spacer IS to one side (e.g., one end) of the bit line connector CN. The third width W3 may have the same value as or a different value from the first width W1 without limitation. For example, the third width W3 may be substantially equal to the first width W1.

Bit line trench regions BTR1 and BTR2 may be defined by the bit line structure BLS. The bit line trench regions BTR1 and BTR2 may include a first bit line trench region BTR1 and a second bit line trench region BTR2. The first bit line trench region BTR1 may be defined by an inner surface BLSa of the bit line structure BLS (e.g., an inner surface BL1a of the first bit line BL1, an inner surface BL2a of the second bit line BL2, and an inner surface CNa of the bit line connector CN). The second bit line trench region BTR2 may be defined by an outer surface BLSb of the bit line structure BLS (e.g., an outer surface BLlb of the first bit line BL1, an outer surface BL2b of the second bit line BL2, and an outer surface CNb of the bit line connector CN). For example, the second bit line trench region BTR2 may be defined between bit line structures BLS neighboring in the second direction D2.

A polysilicon pattern 310 may be provided between the bit line BL and the buffer pattern 210. The polysilicon pattern 310 may be provided in plural. For example, an upper surface of the polysilicon pattern 310 may be positioned at substantially the same height as an upper surface of the bit line contact DC to form a coplanar surface. The polysilicon pattern 310 may include, for example, polysilicon (e.g., polysilicon containing impurities).

A first ohmic pattern 320 may be interposed between the bit line BL and the bit line contact DC and between the bit line BL and the polysilicon pattern 310. The first ohmic pattern 320 may include, for example, metal silicide. A first barrier pattern (not shown) may be further interposed between the bit line BL and the bit line contact DC and between the bit line BL and the polysilicon pattern 310. The first barrier pattern may include, for example, a conductive metal nitride (e.g., nitride of Ti, Mo, W, Cu, Al, Ta, Ru, Ir, etc.).

A bit line capping pattern 350 may be provided on the bit line structure BLS. For example, the bit line capping patterns 350 may be respectively provided on upper surfaces of corresponding bit lines BL. For example, the bit line capping patterns 350 may each extend along the first direction D1 along the corresponding bit line BL and may be spaced apart from each other in the second direction D2. Each of the bit line capping patterns 350 may vertically overlap a corresponding bit line BL. The bit line capping pattern 350 may include a single layer or multiple layers. For example, the bit line capping pattern 350 may include a first capping pattern (not shown), a second capping pattern (not shown), and a third capping pattern (not shown) sequentially stacked. For example, the first to third capping patterns may include silicon nitride. As another example, additional capping patterns such as fourth and fifth capping patterns (not shown) may be further included.

An inner spacer IS may be provided on an inner surface BLSa of the bit line structure BLS. For example, the inner spacer IS may cover an inner surface CNa of the bit line connector CN, and may extend onto (e.g., may continuously extend onto) an inner surface BL1a of the first bit line BL1 and an inner surface BL2a of the second bit line BL2. The inner spacer IS includes a first inner spacer IS 1 on the inner surface BL1a of the first bit line BL1, a second inner spacer IS2 on the inner surface BL2a of the second bit line BL2, and an inner spacer connector ISc physically connecting the first and second inner spacers IS 1 and IS2 on the inner surface CNa of the bit line connector CN. For example, the inner spacer connector ISc may be rounded toward the peripheral region 120 on the inner surface CNa of the bit line connector CN. The bit line structure BLS may extend around (e.g., surround) the inner spacer IS. The inner spacer IS may be provided on an inner wall of the first bit line trench region BTR1. The inner spacer IS may cover one side of the bit line capping pattern 350.

The inner spacer IS may be a single layer or a composite layer. For example, the inner spacer IS may include at least one of silicon nitride, silicon oxide, and silicon oxynitride. As another example, the inner spacer IS may further include an air gap. It will be understood that "air gap" may be, for example, any void or cavity, and may be a gap filled with air (e.g., an air-gap), a gap filled with an inert gas or gases (e.g., an inert gas gap), a gap defining a vacuum (e.g., a vacuum gap), etc.

An outer spacer OS may be provided on an outer surface BLSb of the bit line structure BLS. For example, the outer spacer OS may cover an outer surface CNb of the bit line connector CN, and may extend onto (e.g., may continuously extend onto) an outer surface BL1b of the first bit line BL1 and an outer surface BL2b of the second bit line BL2. The outer spacer OS may include a first outer spacer OS 1 on the outer surface BL1b of the first bit line BL1, a second outer spacer OS2 on the outer surface BL2b of the second bit line BL2, and an outer spacer connector OSc physically connecting the first and second outer spacers OS1 and OS2 on the outer surface CNb of the bit line connector CN. For example, the outer spacer connector OSc may be rounded toward the peripheral region 120 on the outer surface CNb of the bit line connector CN. The outer spacer OS may extend around (e.g., surround) the bit line structure BLS. The outer spacer OS may be provided on an inner wall (e.g., an outer surface BLSb of the bit line structure BLS) of the second bit line trench region BTR2. The outer spacer OS may cover the other side surface of the bit line capping pattern 350.

The outer spacer OS may be a single layer or a composite layer. For example, the outer spacer OS may include at least one of silicon nitride, silicon oxide, and silicon oxynitride. As another example, the outer spacer OS may further include an air gap.

The bit line structure BLS may be interposed between the inner spacer IS and the outer spacer OS. For example, the first bit line BL1 may be interposed between the first inner spacer IS 1 and the first outer spacer OS 1. For example, the second bit line BL2 may be interposed between the second inner spacer IS2 and the second outer spacer OS2. For example, the bit line connector CN may be interposed between the inner spacer connector ISc and the outer spacer connector OSc.

The first inner spacer IS 1 may have a fourth width W4 in the second direction D2. For example, a width of the second inner spacer IS2 in the second direction D2 may be substantially equal to the fourth width W4. The first outer spacer OS 1 may have a fifth width W5 in the second direction D2. For example, a width of the second outer spacer OS2 in the second direction D2 may be substantially equal to the fifth width W5. For example, the fifth width W5 may be substantially equal to the fourth width W4.

The inner spacer IS and the outer spacer OS may minimize electrical interference from adjacent conductive patterns to the bit line structure BLS. For example, the inner spacer IS and the outer spacer OS may minimize electrical interference to the bit line structure BLS from storage node contacts BC, which will be described later. For example, the inner spacer connector ISc and the outer spacer connector OSc may minimize electrical interference to the bit line connector CN from adjacent conductive patterns. As a result, electrical characteristics and reliability of the semiconductor device may be improved.

A storage node contact BC may be provided between neighboring bit lines BL. The storage node contact BC may be provided in plural, and the storage node contacts BC may be spaced apart from each other in first and second directions D1 and D2. For example, some of the storage node contacts BC may be interposed between the first bit line BL 1 and the second bit line BL2 of the bit line structure BLS. As another example, some of the storage node contacts BC may be interposed between bit line structures BLS adjacent to each other in the second direction D2. The storage node contact BC may fill the second recess region RS2 on the edge portion EA of the active pattern ACT. The storage node contact BC may be electrically connected to the edge portion EA. The storage node contact BC may include a conductive material. For example, the storage node contact BC may include at least one of polysilicon (e.g., polysilicon containing impurities) and a metal material (e.g., Ti, Mo, W, Cu, Al, Ta, Ru, Ir, etc.).

Fence patterns (not shown) may space the storage node contacts BC apart from each other on the word lines WL in the first direction D1. For example, the fence patterns may be adjacent to each other in the first direction D1 with the storage node contacts BC interposed therebetween. The fence patterns may include, for example, silicon nitride.

A first dummy pattern DP1 may be provided in the first bit line trench region BTR1. Forexample, the first dummy pattern DP1 may be closer to the peripheral region 120 than an outermost storage node contact BC on the first cell block region CB1. For example, the first dummy pattern DP1 may be extended around by (e.g., surrounded by) the inner surface BLSa of the bit line structure BLS. For example, the first dummy pattern DP1 may include a dummy storage node contact (not shown). As another example, the first dummy pattern DP1 may include a dummy fence pattern (not shown). However, it is not limited thereto, and the first dummy pattern DP 1 may include various patterns and materials filling the first bit line trench region BTR1.

A second dummy pattern DP2 may be provided in the second bit line trench region BTR2. For example, the second dummy pattern DP2 may be closer to the peripheral region 120 than the outermost storage node contact BC. For example, the second dummy pattern DP2 may extend around (e.g., surround) the outer surface BLSb of the bit line structure BLS. For example, the second dummy pattern DP2 may include a dummy storage node contact (not shown). As another example, the second dummy pattern DP2 may include a dummy fence pattern (not shown). However, it is not limited thereto, and the second dummy pattern DP2 may include various patterns and materials filling the second bit line trench region BTR2. For example, the second dummy pattern DP2 may include at least a portion of the same material as a material included in the first dummy pattern DP1.

A second barrier pattern 410 may conformally cover the inner spacer IS, the outer spacer OS, and the storage node contact BC. The second barrier pattern 410 may include, for example, a conductive metal nitride (e.g., a nitride of Ti, Mo, W, Cu, Al, Ta, Ru, or Ir). A second ohmic pattern (not shown) may be further interposed between the second barrier pattern 410 and the storage node contact BC. The second ohmic pattern may include, for example, metal silicide.

A landing pad LP may be provided on the storage node contact BC. The landing pad LP may be provided in plural, and the landing pads LP may be spaced apart from each other in first and second directions D1 and D2. The landing pad LP may be connected to a corresponding storage node contact BC. The landing pad LP may cover an upper surface of the bit line capping pattern 350. An upper portion of the landing pad LP may vertically overlap a portion of the storage node contact BC. For example, a lower portion of the landing pad LP may vertically overlap the storage node contact BC, and the upper portion of the landing pad LP may shift from the lower portion thereof in the second direction D2 or in an opposite direction thereto. The landing pad LP may include a metal material (e.g., Ti, Mo, W, Cu, Al, Ta, Ru, Ir, etc.).

A filling pattern 440 may cover the landing pad LP. The filling pattern 440 may be interposed between adjacent landing pads LP. When viewed in a plan view, the filling pattern 440 may have a mesh shape including holes penetrated by the landing pads LP. For example, the filling pattern 440 may include at least one of silicon nitride, silicon oxide, and silicon oxynitride. As another example, the filling pattern 440 may include an air gap) including an air layer.

A data storage pattern DSP may be provided on the landing pad LP. The data storage pattern DSP may be provided in plural. The plurality of data storage patterns DSP may be spaced apart from each other in first and second directions D1 and D2. Each of the data storage patterns DSP may be electrically connected to a corresponding one of the edge portions EA of the active patterns ACT through a corresponding landing pad LP and a corresponding storage node contact BC.

The data storage pattern DSP may be, for example, a capacitor including a lower electrode, a dielectric layer, and an upper electrode. In this case, the semiconductor memory device according to the present invention may be a dynamic random access memory (DRAM). As another example, the data storage pattern DSP may include a magnetic tunnel junction pattern. In this case, the semiconductor memory device according to the present invention may be a magnetic random access memory (MRAM). As another example, the data storage pattern DSP may include a phase change material or a variable resistance material. In this case, the semiconductor memory device according to the present invention may be a phase-change random access memory (PRAM) or a resistive random access memory (ReRAM). However, this is provided only as an example and the present invention is not limited thereto, and the data storage pattern DSP may include various structures and/or materials capable of storing data.

For example, the peripheral region 120 may be the peripheral region 124 or the core region 126, and in this case, a peripheral word line PWL may be disposed on the peripheral active pattern ACTp. The peripheral active pattern ACTp may include a pair of impurity regions therein, and the peripheral word line PWL may cross the pair of impurity regions when viewed in a plan view. The peripheral word line PWL may include a plurality of patterns sequentially stacked on the peripheral active pattern ACTp and peripheral spacers 355 covering both side surfaces of the patterns. For example, the peripheral word line PWL may include a peripheral dielectric pattern 306, a peripheral polysilicon pattern 310p, a peripheral ohmic pattern 320p, a peripheral electrode pattern BLp that are sequentially stacked, and a pair of peripheral capping pattern 350p covering both sides thereof.

The peripheral dielectric pattern 306 may include, for example, at least one of silicon oxide and a high-k material. The peripheral polysilicon pattern 310p, the peripheral ohmic pattern 320p, and the peripheral electrode pattern BLp may include the same material as those of the polysilicon pattern 310, the first ohmic pattern 320, and the bit line BL, respectively. The peripheral capping pattern 350p may include at least a portion of the same material as a material included in the bit line capping pattern 350. The peripheral spacer 355 may include, for example, at least one of silicon oxide and silicon nitride, and may be a single layer or a composite layer.

A first interlayer insulating layer IL1 may cover the peripheral active pattern ACTp, the device isolation pattern STI, and the peripheral word line PWL on the peripheral region 120. The first interlayer insulating layer IL1 may include an insulating material. For example, the first interlayer insulating layer IL1 may include at least one of silicon oxide, silicon nitride, TEOS, and a low-k material. For example, the first interlayer insulating layer IL1 may be a single layer formed of a single material or a composite layer including two or more materials.

A second interlayer insulating layer IL2 may be disposed on the first interlayer insulating layer IL1. For example, the second interlayer insulating layer IL2 may cover the first interlayer insulating layer IL1. For example, the second interlayer insulating layer IL2 may include at least one of silicon oxide, silicon nitride, TEOS, and a low-k material. For example, the second interlayer insulating layer IL2 may be a single layer formed of a single material or a composite layer including two or more materials.

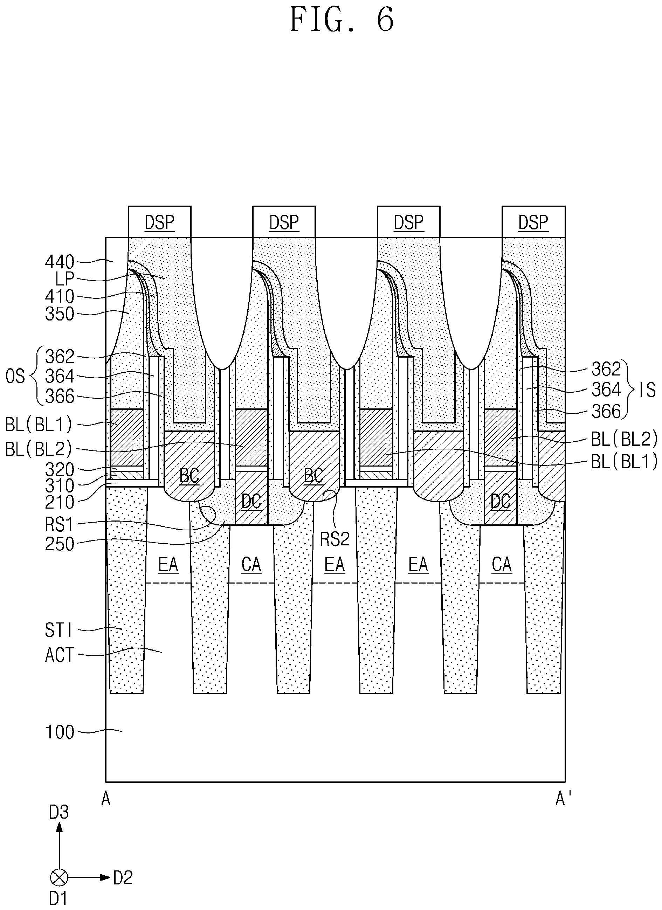

Hereinafter, semiconductor devices according to other embodiments of the present invention will be described with reference to FIGS. 6 to 9. For simplification of the description, descriptions of overlapping contents with the above contents will be omitted, and differences from the above contents will be mainly described.

FIG. 6 is a cross-sectional view corresponding to the line A-A' of FIG. 4A according to some embodiments of the present invention.

Referring to FIG. 6, each of an inner spacer IS and an outer spacer OS may include a plurality of sub-spacers. For example, the inner spacer IS may include a plurality of sub-spacers sequentially provided on the inner surface BL1a of the first bit line BL1 and the inner surface BL2a of the second bit line BL2. For example, the inner spacer IS may include a first sub-spacer 362, a second sub-spacer 364, and a third sub-spacer 366 that are sequentially provided on the inner surface BL1a of the first bit line BL1 and the inner surface BL2a of the second bit line BL2. For example, the outer spacer OS may include a plurality of sub-spacers sequentially provided on the outer surface BL1b of the first bit line BL 1 and the outer surface BL2b of the second bit line BL2. For example, the outer spacer OS may include a first sub-spacer 362, a second sub-spacer 364, and a third sub-spacer 366 that are sequentially provided on the outer surface BL1b of the first bit line BL1 and the outer surface BL2b of the second bit line BL2.

Each of the sub-spacers of the inner spacer IS and the outer spacer OS may include, for example, at least one of silicon nitride, silicon oxide, and silicon oxynitride. As another example, at least some of the plurality of spacers may further include an air gap.

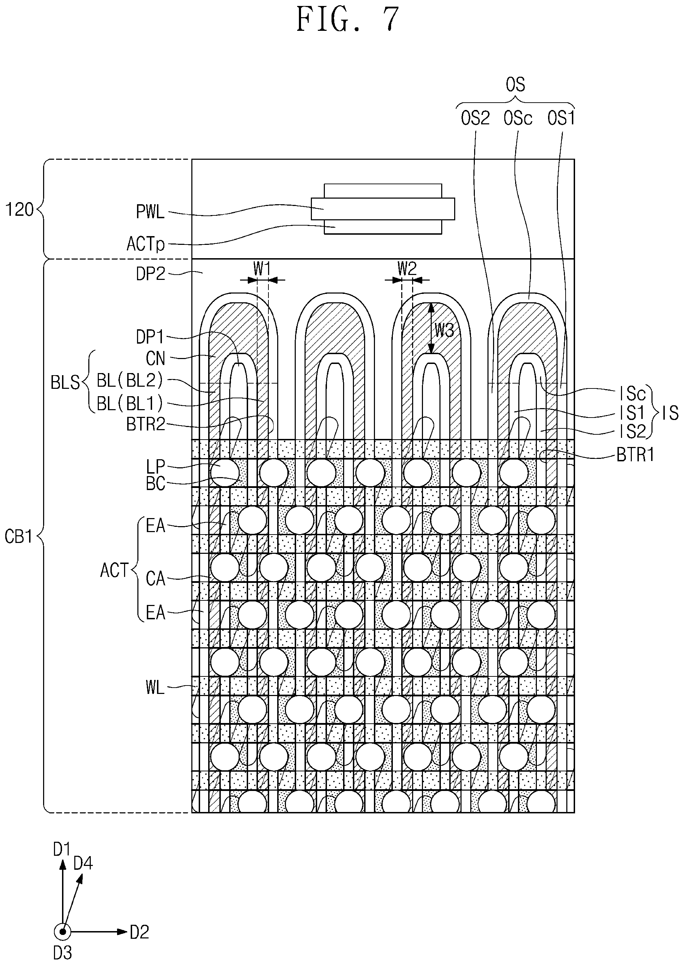

FIG. 7 is a plan view illustrating a portion of a first cell block region and a portion of a peripheral region of FIG. 3A.

Referring to FIG. 7, a third width W3 may be defined as a distance from one end (e.g., one side surface) of the inner spacer IS to one end (e.g., one side surface) of the bit line connector CN. The third width W3 may have a greater value than the first width W1. When the third width W3 has a large value, a resistance value of the bit line connector CN may be reduced, and electrical characteristics of the semiconductor device may be improved.

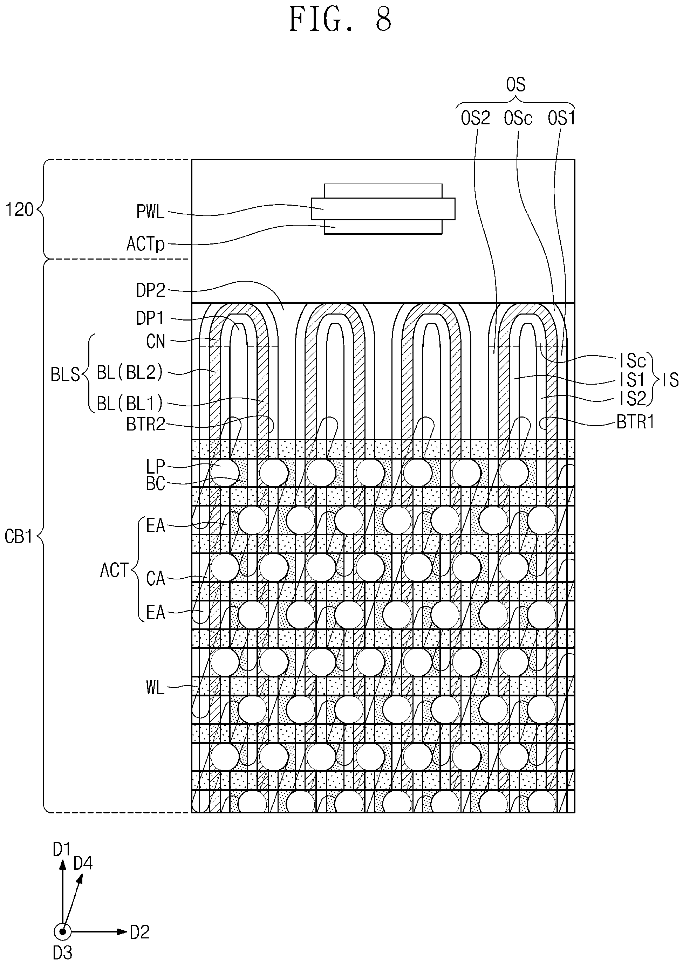

FIG. 8 is a plan view illustrating a portion of a first cell block region CB 1 and a portion of a peripheral region of FIG. 3A.

Referring to FIG. 8, second dummy patterns DP2 may be spaced apart from each other in the second direction D2 with the bit line structures BLS interposed therebetween. For example, the second dummy patterns DP2 may be interposed between outer spacers OS adjacent to each other in the second direction D2. For example, an outer spacer OS may extend around (e.g., surround) a portion of the outer surface CNb of the bit line connector CN, but the present invention is not limited thereto.

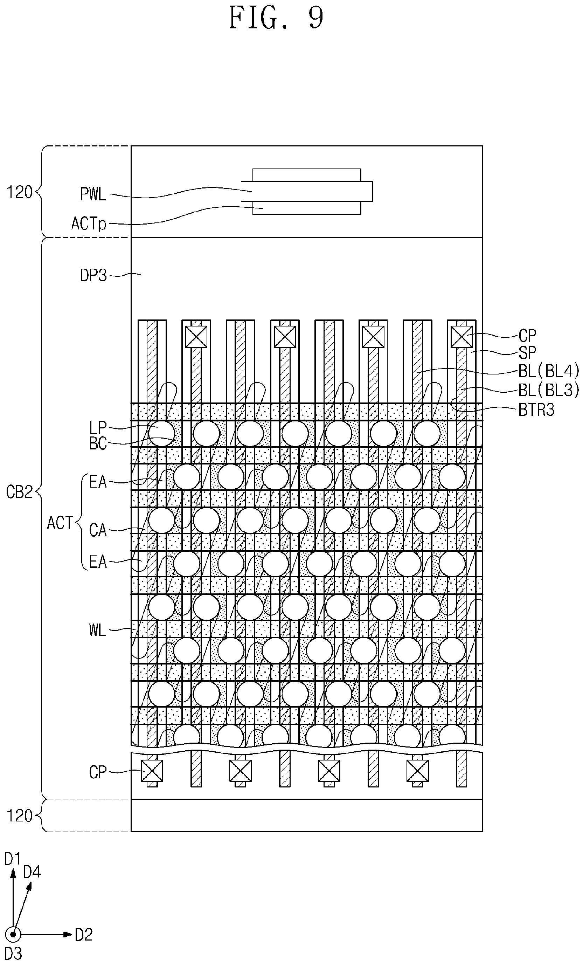

FIG. 9 is a plan view illustrating a portion of a second cell block region CB2 and a portion of a peripheral region of FIG. 3A.

Referring to FIG. 9, a substrate 100 may include a second cell block region CB2 and a peripheral region 120 adjacent to one side of the second cell block region CB2 in the first direction D1. The second cell block region CB2 may be the same as the second cell block region CB2 described with reference to FIG. 3A. The peripheral region 120 may include the scribe lane region 122, the peripheral region 124, and the core region 126 described with reference to FIGS. 1 to 3B. For example, the peripheral region 120 may be a scribe lane region 122, a peripheral region 124, or a core region 126, but the present invention is not limited thereto.

A plurality of bit lines BL may be provided on the second cell block region CB2. The bit lines BL on the second cell block region CB2 may not constitute folded bit lines. The bit lines BL may respectively extend along the first direction D1 on the active patterns ACT and may be spaced apart from each other in the second direction D2. The bit lines BL may be electrically insulated from each other. For example, a third bit line BL3 may be provided on one of the active patterns ACT adjacent to each other in the second direction D2, and a fourth bit line BL4 may be provided on the other one. The third bit line BL3 and the fourth bit line BL4 may be electrically insulated from each other.

A bit line spacer SP may be provided on a side of the bit line BL. For example, the bit line spacer SP may extend along the first direction D1 along a side surface of the bit line BL. The bit line spacer SP may be a single layer or a composite layer. For example, the bit line spacer SP may include at least one of silicon nitride, silicon oxide, and silicon oxynitride. As another example, the bit line spacer SP may further include an air gap.

A third bit line trench region BTR3 may be defined by the bit lines BL on the second cell block region CB2. For example, the third bit line trench region BTR3 may include a trench region between the third and fourth bit lines BL3 and BL4. A third dummy pattern DP3 may fill the third bit line trench region BTR3. For example, the third dummy pattern DP3 may be provided on a region closer to the peripheral region 120 than an outermost storage node contact BC on the second cell block region CB2. For example, the third dummy pattern DP3 may include a dummy storage node contact (not shown). As another example, the third dummy pattern DP3 may include a dummy fence pattern (not shown). However, it is not limited thereto, and the third dummy pattern DP3 may include various patterns and materials filling the third bit line trench region BTR3.

Contact patterns CP may be provided on the bit lines BL. Each of the contact patterns CP may be electrically connected to a corresponding one of the bit lines BL. For example, some of the contact patterns CP may be electrically connected to the third bit lines BL3 and other portions may be electrically connected to the fourth bit lines BL4. For example, some of the contact patterns CP may be provided adjacent to a peripheral region 120 adjacent to one surface of the second cell block region CB2. For example, the other portions of the contact patterns CP may be provided adjacent to a peripheral region 120 adjacent to the other surface of the second cell block region CB2 in an opposite direction to the first direction D1. The one surface and the other surface of the second cell block area CB2 may face each other in the first direction D1. Meanwhile, the present invention is not limited thereto, and an arrangement of the contact patterns CP may be variously modified.

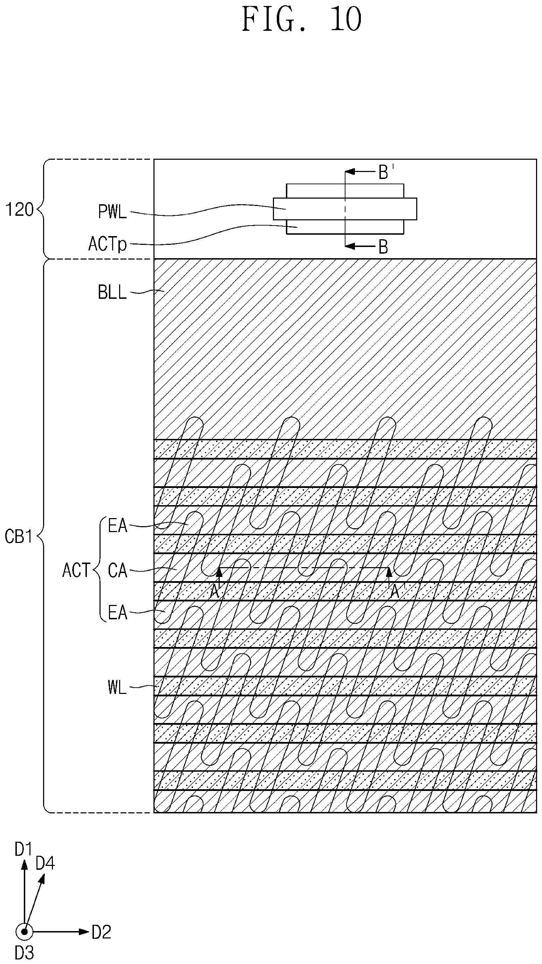

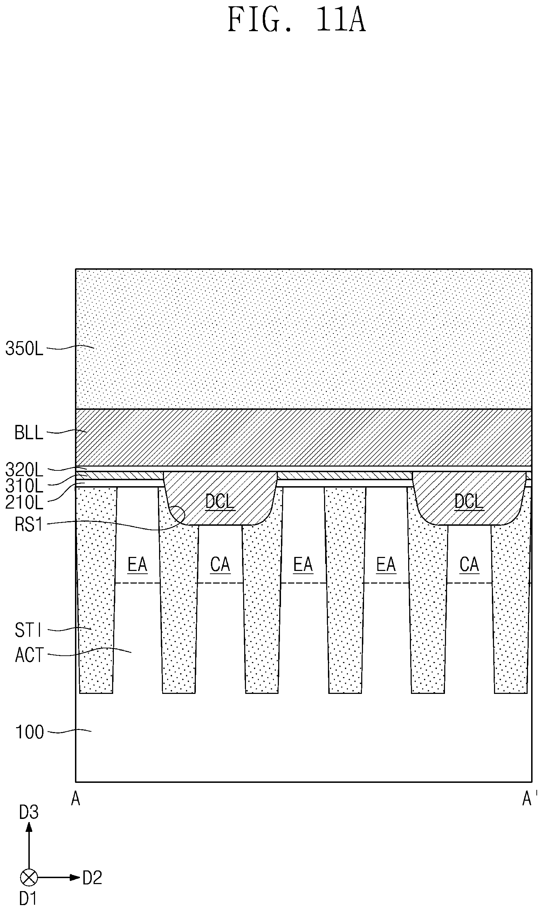

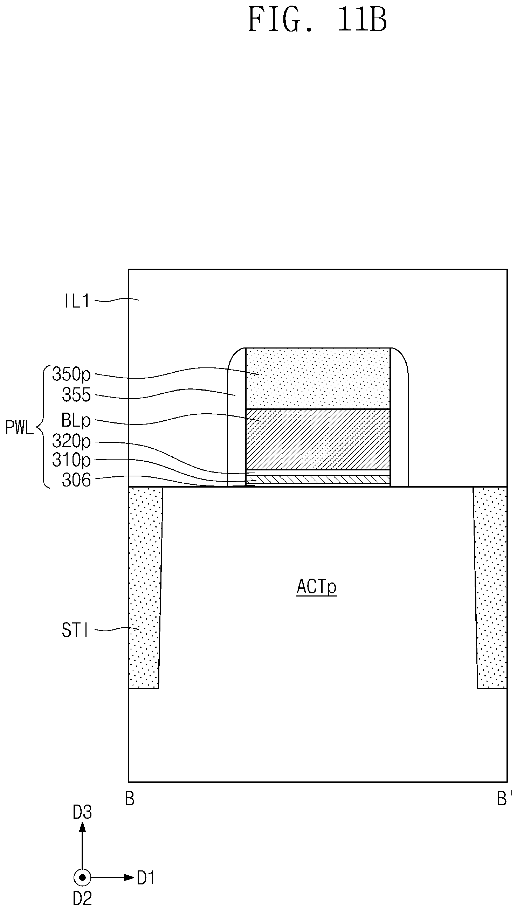

FIGS. 10 to 19B are views illustrating a method of manufacturing a semiconductor device according to some embodiments of the present invention. In detail, FIGS. 10, 12, 14, 16, and 18 are plan views illustrating a portion of a first cell block region CB1 and a portion of a peripheral region of FIG. 3A, respectively. FIGS. 11A, 13A, 15A, 17A, and 19A are cross-sectional views taken along the lines A-A' of FIGS. 10, 12, 14, 16, and 18, respectively. FIGS. 11b, 13b, 15b, 17b, and 19b are cross-sectional views taken along the lines B-B' of FIGS. 10, 12, 14, 16, and 18, respectively.

Hereinafter, a method of manufacturing a semiconductor device according to some embodiments of the present invention will be described with reference to FIGS. 10 to 19B. For simplicity of description, descriptions of contents overlapping with the above descriptions will be omitted, and differences from the above will be mainly explained.

Referring to FIGS. 10, 11A, and 11B, a substrate 100 including a first cell block region CB1 and a peripheral region 120 adjacent to each other in a first direction D1 may be provided or prepared.

A device isolation pattern STI, active patterns ACT, and a peripheral active pattern ACTp may be formed on the substrate 100. Forming the device isolation pattern STI and the active pattern ACT may include forming a trench region in the substrate 100 through patterning, and filling the trench region with an insulating material to form the device isolation pattern STI. The active patterns ACT may be portions of the substrate 100 on which the trench region is not formed on the first cell block region CB1. The peripheral active pattern ACTp may be another portion of the substrate 100 in which the trench region is not formed on the peripheral region 120.

Word lines WL may be formed on the first cell block region CB1. The word lines WL may be formed to cross the active patterns ACT and the device isolation pattern STI in the second direction D2. Forming the word lines WL may include forming mask patterns on the active patterns ACT and the device isolation pattern STI, performing an anisotropic etching process using the mask patterns to form trench regions, and filling the trench regions with word lines WL. The word lines WL may be spaced apart from each other in the first direction D1.

For example, a pair of word lines WL may cross the active pattern ACT, and a center portion CA of the active pattern ACT disposed between the pair of word lines WL may be defined. Other portions of the active pattern ACT spaced apart from the center portion CA with each of the pair of word lines WL interposed therebetween may be defined as edge portions EA.

A buffer layer 210L may be formed on the first cell block region CB1, and a peripheral dielectric layer (not shown) may be formed on the peripheral region 120. The buffer layer 210L may cover an upper surface of the active pattern ACT, an upper surface of the device isolation pattern STI, and an upper surface of the word line WL. The peripheral dielectric layer may cover the peripheral active pattern ACTp on the peripheral region 120.

A polysilicon layer 310L may be formed on the buffer layer 210L and the peripheral dielectric layer. Then, on the first cell block region CB1, a first recess region RS1 may be formed on the center portion CA of the active pattern ACT. The first recess region RS1 may be provided in plural. The first recess regions RS 1 may be spaced apart from each other in first and second directions D1 and D2. Forming the first recess region RS1 may include performing an anisotropic etching process on the polysilicon layer 310L, the buffer layer 210L, and the center portion CA of the active pattern ACT. The first recess region RS 1 may expose the center portion CA of the active pattern ACT.

A preliminary bit line node contact DCL may be formed to fill the first recess region RS 1. The preliminary bit line node contact DCL may be provided in plural, and may be formed on the center portions CA of the active patterns ACT, respectively. For example, an upper surface of the preliminary bit line node contact DCL may be formed at substantially the same height as the upper surface of the polysilicon layer 310L to be coplanar.

A first ohmic layer 320L, a bit line layer BLL, and a bit line capping layer 350L may be sequentially stacked on the first cell block region CB1 and the peripheral region 120. On the peripheral region 120, the bit line capping layer 350L, the bit line layer BLL, the first ohmic layer 320L, the polysilicon layer 310L, and the peripheral dielectric layer may be patterned through an etching process. A capping pattern 350p, a peripheral electrode pattern BLp, a peripheral ohmic pattern 320p, a peripheral polysilicon pattern 310p, and a peripheral dielectric pattern 306 may be formed. Thereafter, peripheral spacers 355 covering side surfaces thereof and a first interlayer insulating layer IL1 covering the peripheral spacers 355 may be formed. In this process, an additional capping layer (not shown) may be further formed on the remaining bit line capping layer 350L on the first cell block region CB1.

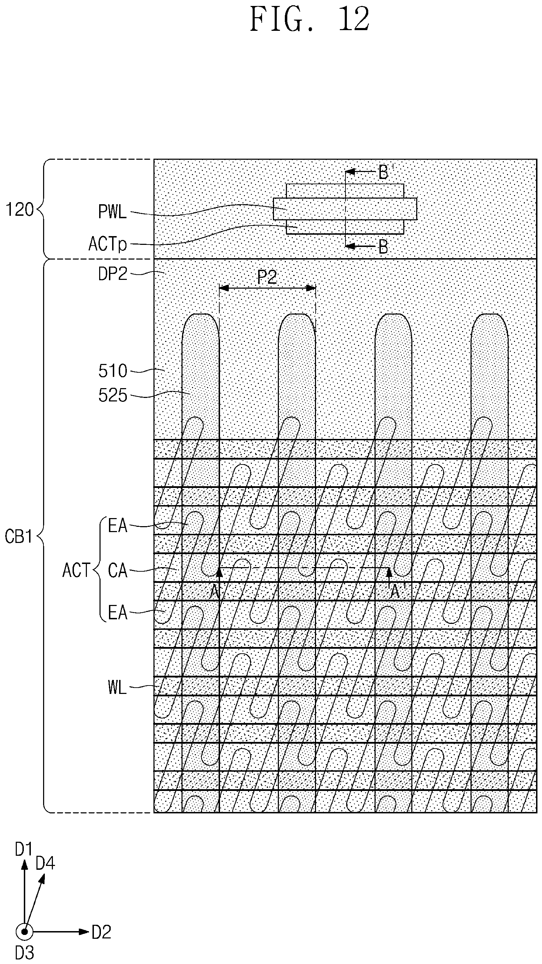

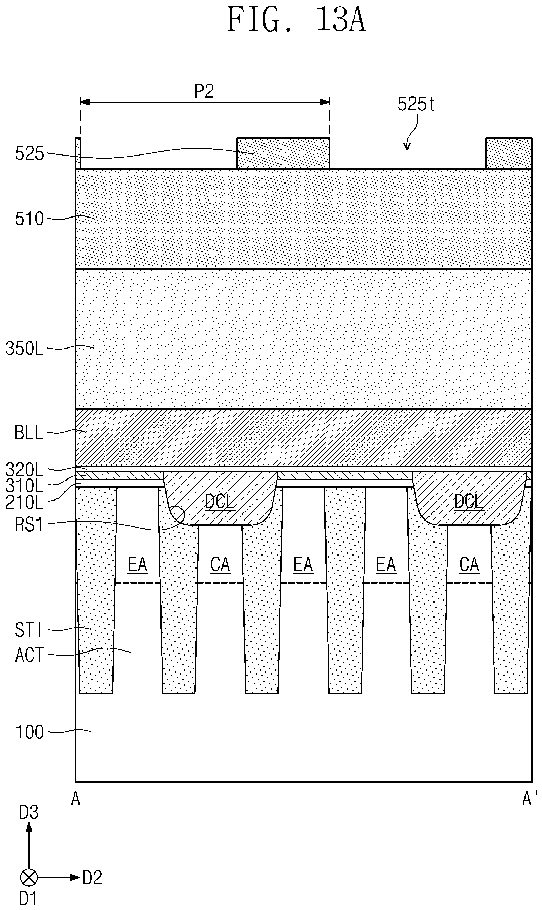

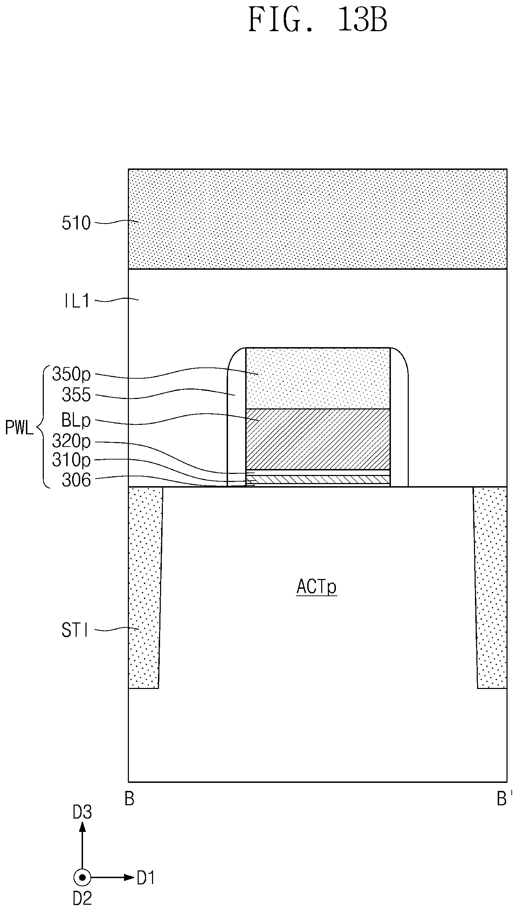

Referring to FIGS. 12, 13A, and 13B, a lower mask layer 510 may be formed on the first cell block region CB1 and the peripheral region 120. For example, the lower mask layer 510 may cover an entire surface of the substrate 100. Upper mask patterns 525 may be formed on the lower mask layer 510. Forming the upper mask patterns 525 may include forming an upper mask layer (not shown) on the lower mask layer 510 and patterning the upper mask layer through an etching process to form the upper mask patterns 525.

For example, although not shown, an additional mask layer may be further formed under the lower mask layer 510 and/or between the lower mask layer 510 and the upper mask layer, and the present invention is not limited to the number of the additional mask layers. As another example, each of the lower mask layer 510 and the upper mask layer may be a mask layer in which a plurality of material layers are sequentially stacked.

The upper mask patterns 525 may be formed on the first cell block region CB1. The upper mask patterns 525 may extend along the first direction D1 and may be spaced apart from each other in the second direction D2. In the first direction D1, an end of each of the upper mask patterns 525 may be formed to be farther apart from the peripheral region 120 than an end of the bit line layer BLL. For example, the upper mask patterns 525 may not be formed on the peripheral region 120. Upper mask trench regions 525t may be defined between upper mask patterns.

The upper mask patterns 525 may have a second pitch P2 in the second direction D2. For example, the second pitch P2 may be substantially the same as the first pitch P1. For example, the second pitch P2 may be greater than 0 nm and may be equal to or less than 130 nm.

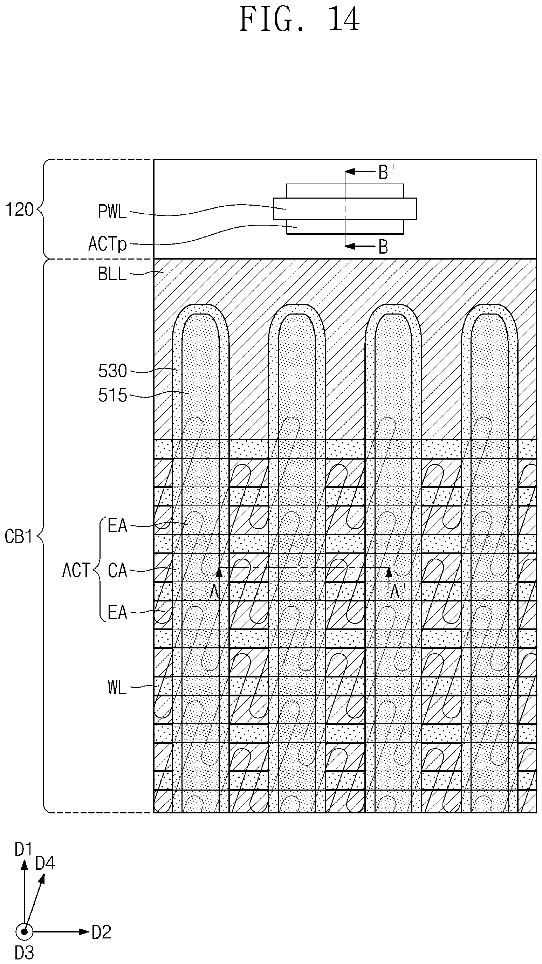

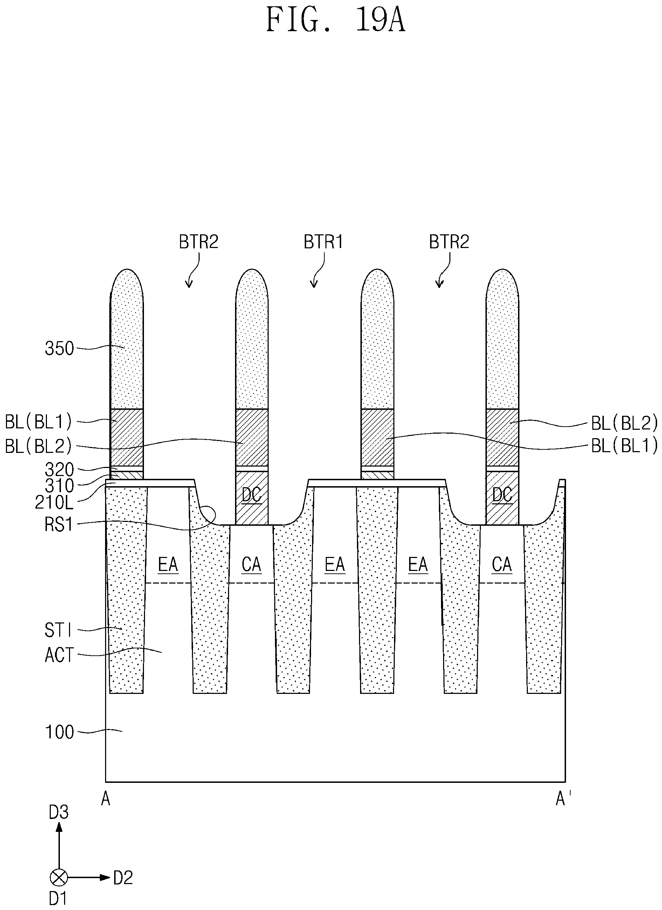

The lower mask layer 510 and the upper mask patterns 525 may be used for multi-patterning technology to form the bit line structure BLS of FIG. 4A. For example, the multi-patterning technology may include a double patterning technology (DPT) such as lithography-etch-lithography-etch (LELE), self-aligned double patterning (SADP), self-aligned reverse patterning (SARP), or quadruple patterning technology (QPT) such as lithography-etch-lithography-etch-lithography-etch (LELELE) and self-aligned quadruple patterning (SAQP). For example, like a manufacturing method described below with reference to FIGS. 14 to 19B, a method of manufacturing a semiconductor device may be performed using a double patterning technique.

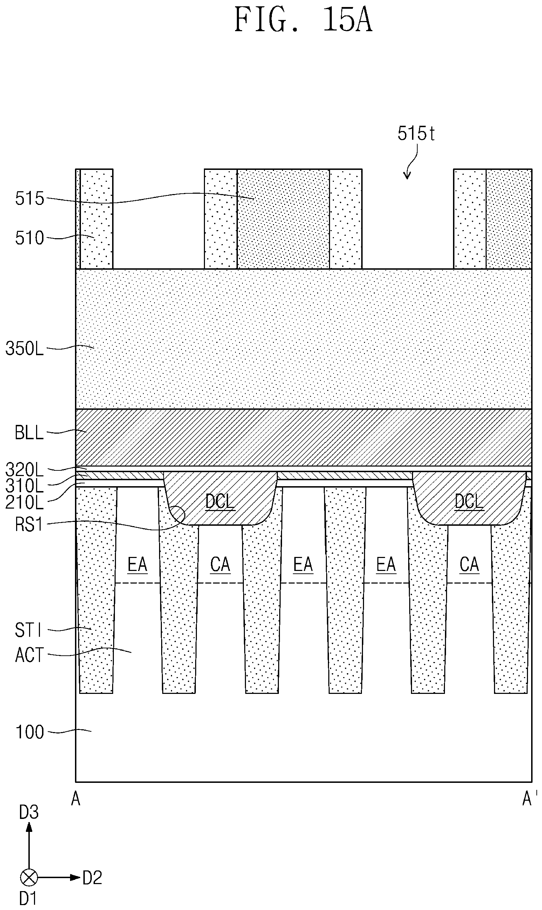

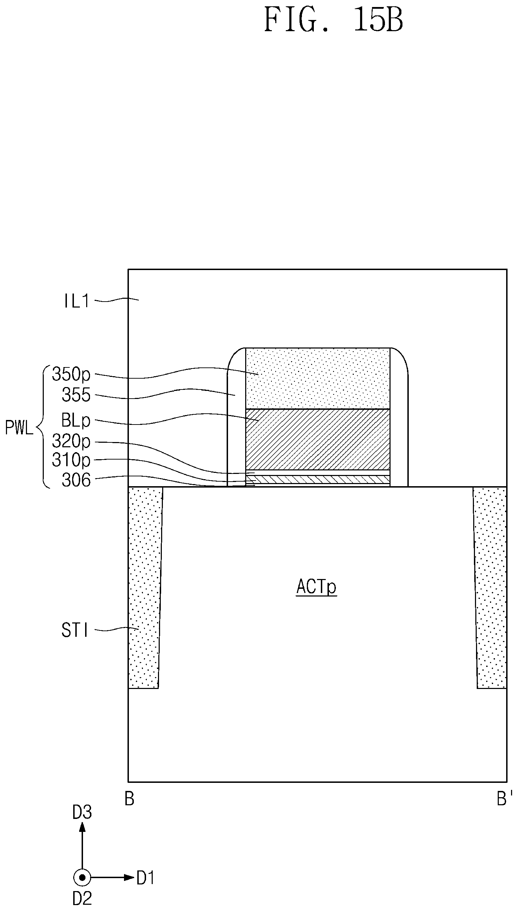

Referring to FIGS. 14, 15A, and 15B, the lower mask layer 510 may be etched using the upper mask patterns 525 as an etch mask to form lower mask patterns 515. The lower mask patterns 515 may be formed on the first cell block region CB1. The lower mask patterns 515 may extend along the first direction D1 and may be spaced apart from each other in the second direction D2. In the first direction D1, an end of each of the lower mask patterns 515 may be formed to be farther from the peripheral region 120 than an end of the bit line layer BLL. For example, the lower mask patterns 515 may not be formed on the peripheral region 120. Lower mask trench regions 515t may be defined between lower mask patterns 515.

Spacer mask patterns 530 may be formed on side surfaces of the lower mask patterns 515. Forming the spacer mask patterns 530 may include forming a spacer mask layer (not shown) on the entire surface of the substrate 100 and etching the spacer mask layer to form spacer mask patterns 530 on side surfaces of the lower mask patterns 515.

When viewed in a plan view, each of the spacer mask patterns 530 may extend around (e.g., surround) each side of the lower mask patterns 515. For example, each of the spacer mask patterns 530 may extend around (e.g., surround) an end of each of the lower mask patterns 515 in the first direction D1. The ends of the spacer mask patterns 530 in the first direction D1 may be spaced apart from the peripheral region 120. For example, ends of the spacer mask patterns 530 in the first direction D1 may be rounded toward the peripheral region 120.

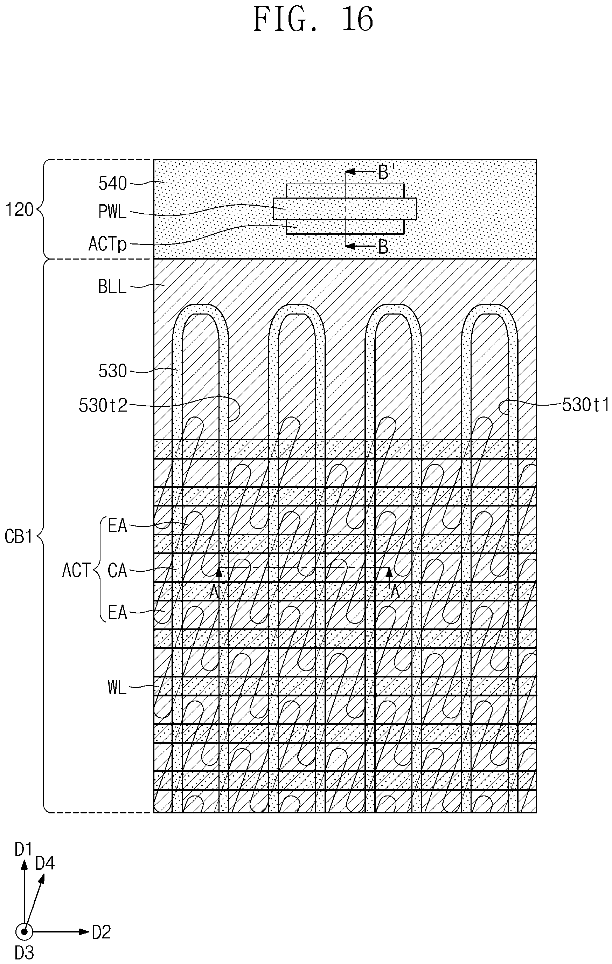

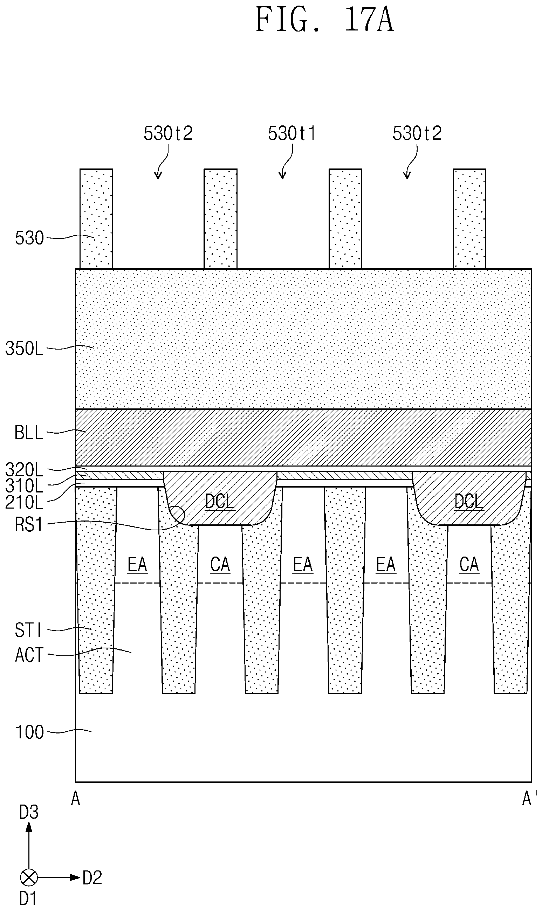

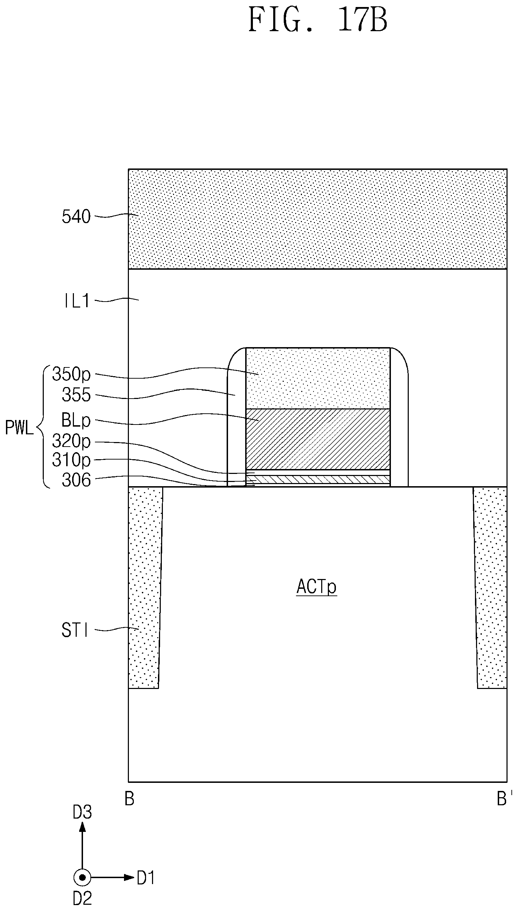

Referring to FIGS. 16, 17A, and 17B, the lower mask patterns 515 may be removed. The spacer mask patterns 530 may remain. A first spacer mask trench region 530t1 and a second spacer mask trench region 530t2 may be defined by the spacer mask patterns 530. The first spacer mask trench region 530t1 may be a region extended around by (e.g., surrounded by) the spacer mask patterns 530 and may be a region from which the lower mask patterns 515 are removed. The second spacer mask trench region 530t2 may be a region extending around (e.g., surrounding) the spacer mask patterns 530.

A peripheral mask pattern 540 may be formed on the peripheral region 120. For example, the peripheral mask pattern 540 may not be formed on the first cell block region CB1. When viewed in a plan view, the peripheral mask pattern 540 may be spaced apart from the spacer mask patterns 530 in the first direction D1. For example, when viewed in a plan view, the peripheral mask pattern 540 may be spaced apart from a bit line layer BLL in the first direction D1.

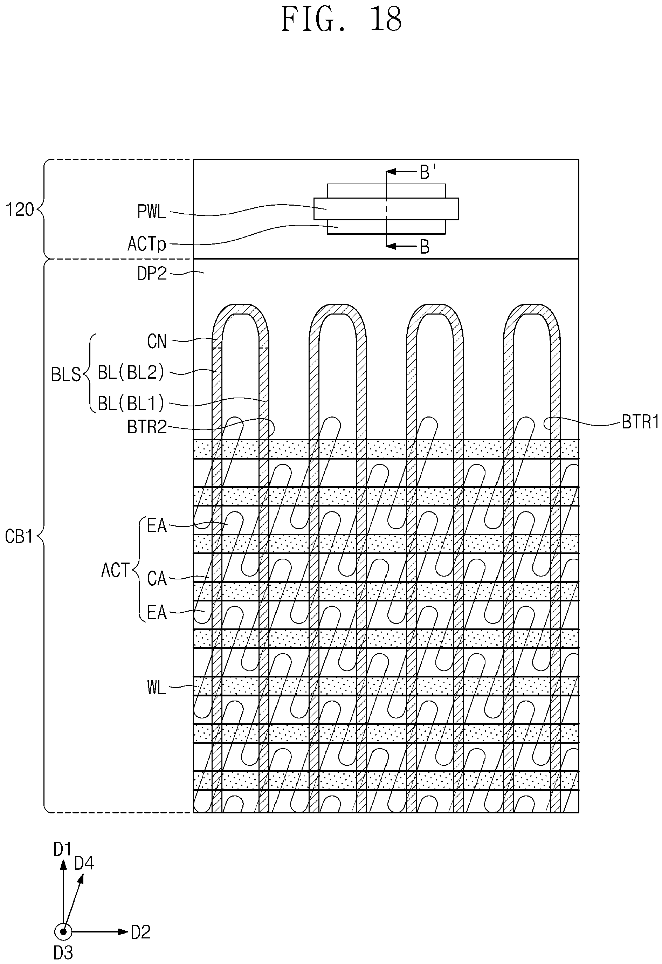

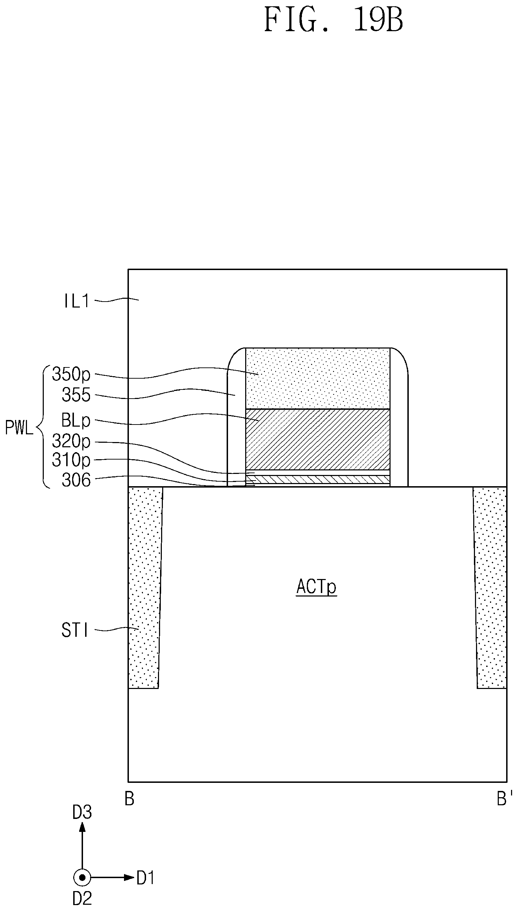

Referring to FIGS. 18, 19A, and 19B, an etching process may be performed using the spacer mask pattern 530 and the peripheral mask pattern 540 as an etching mask. Through the etching process, the bit line capping layer 350L, the bit line layer BLL, the first ohmic layer 320L, the polysilicon layer 310L, and the preliminary bit line node contact DCL may be etched to form a bit line capping pattern 350, a bit line structure BLS, and a bit line node contact DC. For example, the bit line structure BLS may be formed to have a profile similar to that of the spacer mask pattern 530. The first bit line trench regions BTR1 and the second bit line trench regions BTR2 may be formed under the first spacer mask trench region 530t1 and the second spacer mask trench region 530t2 of FIG. 16, respectively. Despite the etching process, patterns on the peripheral region 120 such as the peripheral word line PWL may remain without being etched by the peripheral mask pattern 540.

Through the etching process, the bit line connector CN may be formed during the patterning process for forming the bit lines BL without a separate patterning process. Accordingly, productivity of the semiconductor device may be improved.

Referring back to FIGS. 4A and 4B, an inner spacer IS may be formed on an inner surface BLSa of the bit line structure BLS, and an outer spacer OS may be formed on an outer surface BLSb of the bit line structure BLS. The inner spacer IS may be formed in the first bit line trench region BTR1, and the outer spacer OS may be formed in the second bit line trench region BTR2. For example, in the process of forming the inner spacer IS and the outer spacer OS, a buried insulating pattern 250 filling the first recess region RS 1 may be formed. For example, forming the inner spacer IS and the outer spacer OS may include sequentially forming a plurality of sub-spacers on side surfaces of the bit line structure BLS.

A second recess region RS2 may be formed on the edge portion EA of the active pattern ACT. Forming the second recess region RS2 may include removing a portion of the buffer layer 210L on the edge portion EA of the active pattern ACT to form a buffer pattern 210.

A storage node contact BC may be formed to fill the second recess region RS2. The storage node contact BC may be electrically connected to the edge portion EA of the active pattern ACT in the second recess region RS2. Forming the storage node contact BC may include forming a storage node contact layer (not shown) filling the second recess region RS2 and removing an upper portion of the storage node contact layer to form a plurality of storage node contacts BC. Removing the upper portion of the storage node contact layer may further include an etch-back or polishing process, but the present invention is not limited thereto.

A fence pattern (not shown) may be formed on the word lines WL before or after forming the storage node contact BC. The fence pattern may be formed to space the storage node contacts BC apart in the first direction D 1.

When the storage node contact BC and the fence pattern are formed, a first dummy pattern DP1 and a second dummy pattern DP2 may be formed in the first bit line trench region BTR1 and the second bit line trench region BTR2, respectively. The first dummy pattern DP 1 and the second dummy pattern DP2 may be formed adjacent to the peripheral region 120.

Landing pads LP may be formed on the storage node contacts BC. Forming the landing pads LP may include sequentially forming a landing pad layer (not shown) and mask patterns (not shown) covering upper surfaces of the storage node contacts BC, and separating the landing pad layer into a plurality of landing pads LP through anisotropic etching using the mask patterns as an etching mask.

Thereafter, a filling pattern 440 may be formed in the region from which the landing pad layer is removed. The filling pattern 440 may be formed to extend around (e.g., surround) each of the landing pads LP. A data storage pattern DSP may be formed on each of the landing pads LP. A second interlayer insulating layer IL2 may be formed on the first interlayer insulating layer L 1.

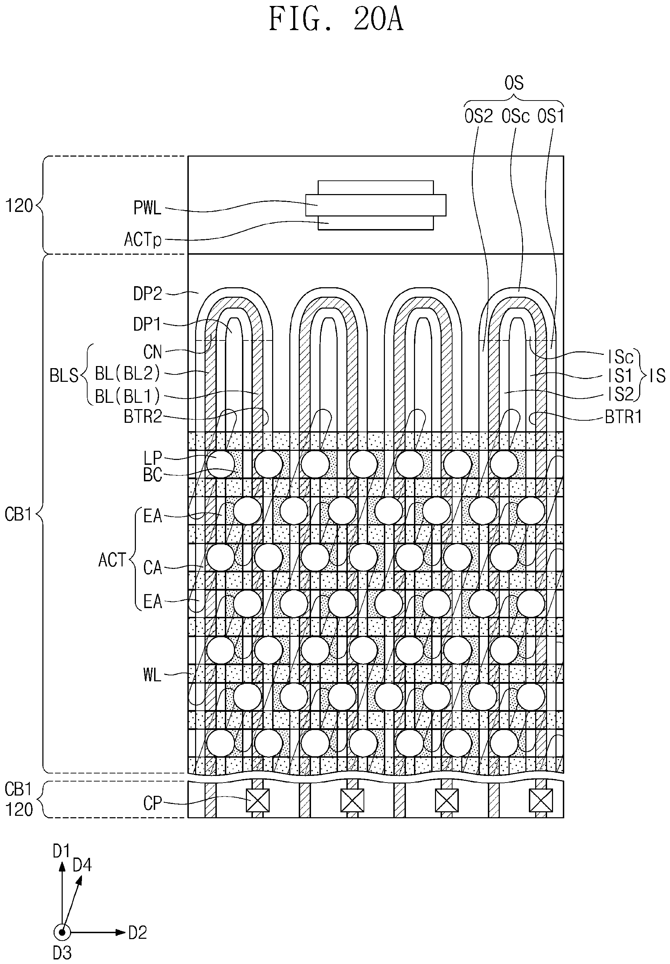

FIGS. 20A to 20E are plan views illustrating a portion of a first cell block region CB 1 and a portion of the peripheral region of FIG. 3A. Hereinafter, with reference to FIGS. 20A to 20E, various embodiments of arrangement of contact patterns in a semiconductor device according to the present invention will be described. For simplification of the description, descriptions of overlapping contents with the above contents will be omitted, and differences from the above contents will be mainly described.

Referring to FIGS. 20A to 20E, the contact pattern CP may be provided on the bit line structure BLS. Each of the contact patterns CP may be electrically connected to a corresponding one of the bit line structures BLS. For example, when an electrical signal is applied to one contact pattern CP, the first bit line BL1 and the second bit line BL2 of the corresponding bit line structure BLS may be driven together. The contact patterns CP may be arranged in various shapes.

Referring to FIGS. 20A to 20C, a contact pattern CP may be connected to either a first bit line BL1 or a second bit line BL2 of a corresponding bit line structure BLS. For example, a contact pattern CP may be adjacent to an end of one of the first bit line BL1 or the second bit line BL2, and the end may be a portion of the first bit line BL 1 or the second bit line BL2 facing the bit line connector CN in the first direction D1.

For example, as shown in FIG. 20A, each of the contact patterns CP may be connected to a first bit line BL1 of a corresponding bit line structure BLS, and may be connected to the second bit line BL2 through the first bit line BL1 and the bit line connector CN. Each of the contact patterns CP may be provided on either the first cell block region CB1 or the peripheral region 120.

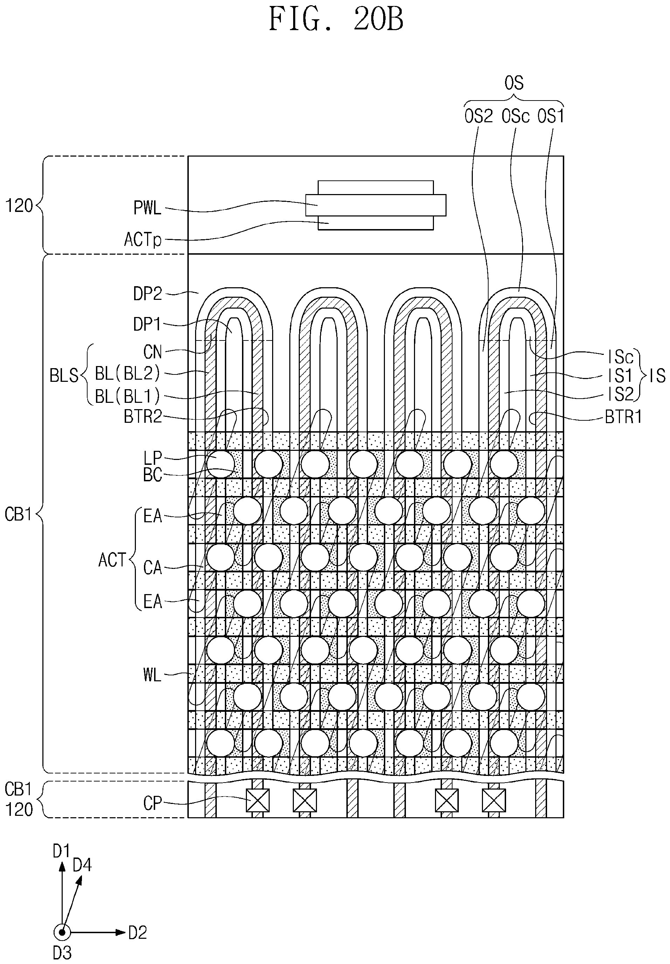

As another example, as shown in FIG. 20B, some of the contact patterns CP may be connected to the first bit line BL1 of the corresponding bit line structure BLS, and may be connected to the second bit line BL2 through the first bit line BL1 and the bit line connector CN. Other contact patterns CP may be connected to the second bit line BL2 of the corresponding bit line structure BLS, and may be connected to the first bit line BL1 through the second bit line BL2 and the bit line connector CN. Each of the contact patterns CP may be provided on either the first cell block region CB1 or the peripheral region 120.

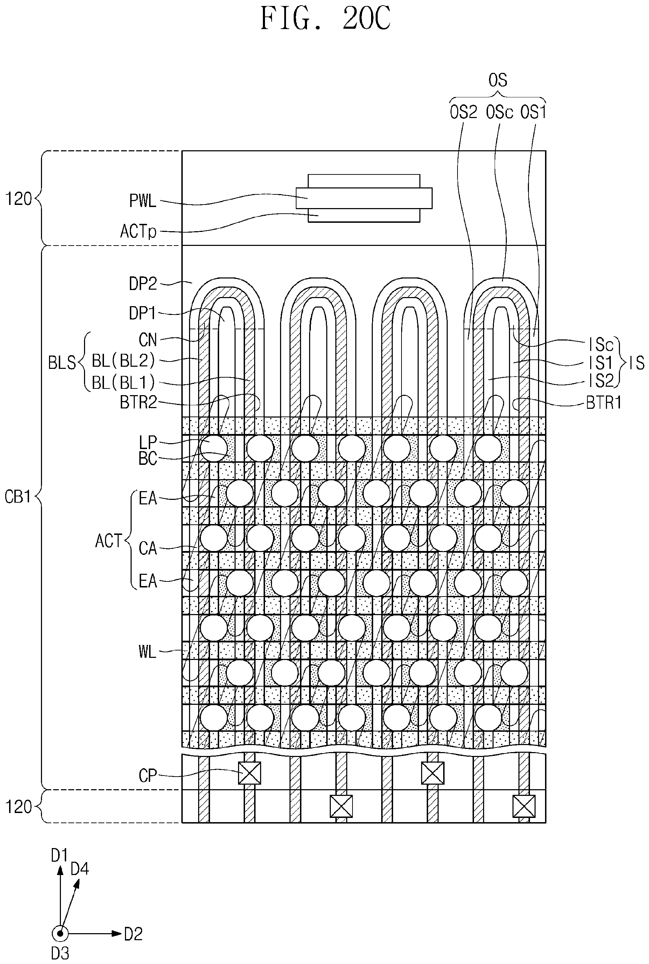

As another example, as shown in FIG. 20C, some of the contact patterns CP may be provided on the first cell block region CB1 and other contact patterns CP may be provided on the peripheral region 120. For example, a certain contact pattern CP may be provided on the peripheral region 120, and a contact pattern CP adjacent to the contact pattern CP in the second direction D2 may be provided. The neighboring contact pattern CP may be provided by being shifted in the first direction D1 from the contact pattern CP, and may be provided on the first cell block region CB1.

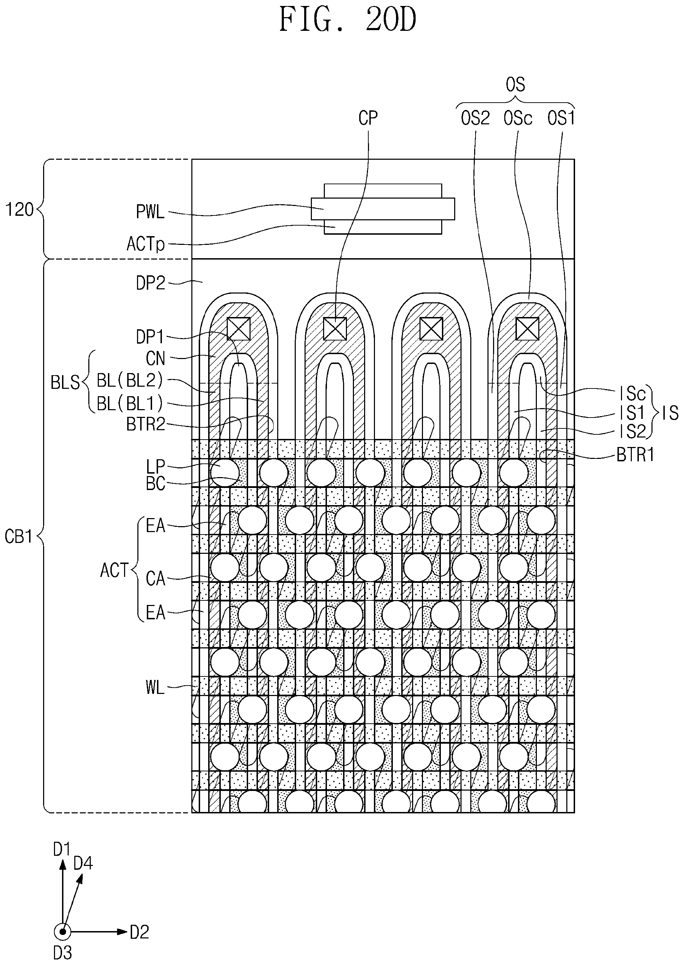

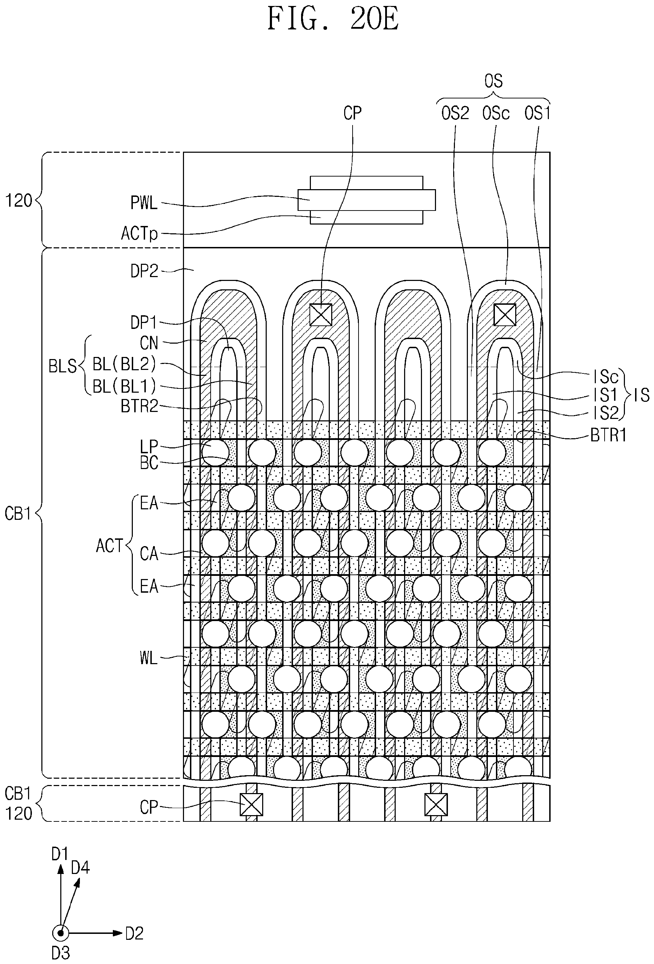

Referring to FIGS. 20D and 20E, at least some of the contact patterns CP may be connected to the bit line connector CN. For example, the contact pattern CP may be connected to one of the first bit line BL1, the second bit line BL2, or the bit line connector CN of the corresponding bit line structure BLS.

For example, as shown in FIG. 20D, each of the contact patterns CP may be connected to a bit line connector CN of a corresponding bit line structure BLS. Each of the contact patterns CP may be connected to each of the first bit line BL1 and the second bit line BL2 through the bit line connector CN of the corresponding bit line structure BLS.

As another example, as shown in FIG. 20E, some of the contact patterns CP may be connected to the bit line connector CN of the corresponding bit line structure BLS. Some of the contact patterns CP may be connected to each of the first bit line BL1 and the second bit line BL2 through the bit line connector CN of the corresponding bit line structure BLS. Other contact patterns CP may be connected to either the first bit line BL1 or the second bit line BL2 of the corresponding bit line structure BLS.

The arrangement of the contact patterns CP is not limited to the embodiments described with reference to FIGS. 20A to 20E, and it should be understood that all of the above embodiments are illustrative.

According to some embodiments of the present invention, when the bit line structure includes the bit line connector, the folded bit line may be provided, and thus the integration of the semiconductor device may be improved. In addition, the folded bit line may be formed through the multi-patterning technique, thereby improving the productivity of the semiconductor device.

Furthermore, the inner spacer and the outer spacer may be formed to extend around by (e.g., surround) the bit line structure, the electrical interference from adjacent conductive patterns to the bit line structure may be minimized.

Although terms (e.g., first, second or third) may be used herein to describe various elements, these elements should not be limited by these terms. These terms are only used to distinguish one element from another. For example, a first element may be referred to as a second element, and, similarly a second element may be referred to as a first element without departing from the teachings of the disclosure.

As used herein, an element or region that is "covering" or "surrounding" or "filling" another element or region may completely or partially cover or surround or fill the other element or region.

While some embodiments are described above, a person skilled in the art may understand that many modifications and variations can be made without departing from the scope of the present invention defined in the following claims. Accordingly, example embodiments of the present invention described herein should be considered in all respects as illustrative and not restrictive, with the scope of the present invention being indicated by the appended claims.

## Claims

1. A semiconductor device comprising:
a substrate including a cell block region and a peripheral region adjacent to each other in a first direction;
first and second active patterns adjacent to each other in a second direction that is different from the first direction on the cell block region;
a first bit line extending in the first direction on the first active pattern;
a second bit line extending in the first direction on the second active pattern;
a bit line connector connecting the first bit line and the second bit line to each other and adjacent to the peripheral region;
an inner spacer on an inner surface of the bit line connector; and
an outer spacer on an outer surface of the bit line connector,
wherein the inner spacer extends on the inner surface of the bit line connector and continuously extends onto inner surfaces of the first bit line and the second bit line.

2. The semiconductor device of claim 1, wherein the bit line connector is between the inner spacer and the outer spacer.

3. The semiconductor device of claim 1 or 2, wherein the peripheral region is a scribe lane region or a peripheral region.

4. The semiconductor device of claim 1, 2 or 3, wherein the bit line connector is curved toward the peripheral region in a plan view.

5. The semiconductor device of any preceding claim, wherein the outer spacer is curved toward the peripheral region in a plan view.

6. The semiconductor device of any preceding claim, wherein the outer spacer extends around the outer surface of the bit line connector.

7. The semiconductor device of any preceding claim, wherein the outer spacer extends on the outer surface of the bit line connector and continuously extends onto outer surfaces of the first bit line and the second bit line.

8. The semiconductor device of any preceding claim, wherein the inner spacer includes a plurality of sub-spacers sequentially stacked on the inner surface of the first bit line, and
wherein an outer spacer includes a plurality of sub-spacers sequentially stacked on an outer surface of the first bit line.

9. The semiconductor device of any preceding claim, wherein a pitch of the first and second bit lines in the second direction is greater than 0 nm and is less than or equal to 130 nm.

10. The semiconductor device of any preceding claim, wherein a width of the first bit line in the second direction is wider than 0 nm and is less than or equal to 14 nm.

11. The semiconductor device of any preceding claim, wherein a width of the first bit line in the second direction is narrower than or is equal to a distance from one end of the inner spacer to one end of the bit line connector.

12. The semiconductor device of any preceding claim, wherein the cell block region is a first cell block region,
wherein the substrate further includes a second cell block region spaced apart from the first cell block region in the first direction,
wherein the semiconductor device further includes:
a third active pattern and a fourth active pattern adjacent to each other in the second direction on the second cell block region;
a third bit line extending in the first direction on the third active pattern; and
a fourth bit line extending in the first direction on the fourth active pattern, and
wherein the third bit line is electrically insulated from the fourth bit line.

13. A method of manufacturing a semiconductor device, the method comprising:
providing a substrate including a cell block region and a peripheral region adjacent to each other in a first direction;
forming a bit line layer on the cell block region;
forming lower mask patterns that are on the bit line layer and extend in the first direction;
forming spacer mask patterns extending around side surfaces of the lower mask patterns;
forming a peripheral mask pattern that is on the peripheral region and is spaced apart from the spacer mask patterns in the first direction; and
etching the bit line layer using the spacer mask pattern and the peripheral mask pattern as etching masks to form bit line structures.

14. The method of claim 13, wherein each of the bit line structures includes:
a first bit line extending in the first direction;
a second bit line that extends in the first direction and is adjacent to the first bit line in a second direction that is different from the first direction; and
a bit line connector that connects the first bit line and the second bit line to each other and is adjacent to the peripheral region.
